# EUROPEAN PATENT APPLICATION

(11) **EP 2 034 515 A1**
(43) Date of publication of application: **11.03.2009**
(21) Application number: 07743953.7
(22) Date of filing: 23.05.2007
(51) Int. Cl.: H01L 21/027, G03F 7/20

(54) **MAINTENANCE METHOD, EXPOSURE METHOD AND APPARATUS, AND DEVICE MANUFACTURING METHOD**

(30) Priority: 23.05.2006 JP 2006143451; 30.05.2006 JP 2006149277; 30.05.2006 JP 2006150746
(71) Applicant: Nikon Corporation, Tokyo 100-8331 (JP)
(72) Inventor: SHIBAZAKI, Yuichi, Tokyo 100-8331 (JP); MIZUTANI, Takeyuki, Tokyo 100-8331 (JP); ICHINOSE, Go, Tokyo 100-8331 (JP); SHIBUTA,Makoto, Tokyo 100-8331 (JP)
(74) Representative: HOFFMANN EITLE
(86) International application number: PCT/JP2007/060519
(87) International publication number: WO 2007/136089

(57) **Abstract**

A maintenance method for performing maintenance of an exposure apparatus including a liquid immersion space-forming member (30) which forms a liquid-immersion area by supplying liquid (1) in a space between an optical member (2) and a substrate (P); a liquid supply mechanism (10) which supplies the liquid (1) to the liquid-immersion space; a substrate stage (PST) which moves the substrate (P); and a measuring stage (MST) on which a reference mark is formed. To clean the liquid-immersion space-forming member (30), a cleaning liquid is supplied to a space between the measuring stage (MST) and the liquid-immersion space-forming member (30). The exposure apparatus is provided with various types of cleaning mechanisms for cleaning the liquid-immersion space-forming member (30). The liquid-immersion exposure can be performed while efficiently performing maintenance of the exposure apparatus.

## Description

### TECHNICAL FIELD

The present invention relates to a maintenance technique for an exposure apparatus which exposes a substrate with an exposure light (exposure light beam) via an optical member (for example, a projection optical system) and a liquid. The present invention also relates to an exposure technique and a technique for producing a device using the maintenance technique.

### BACKGROUND ART

A microdevice (electronic device) which includes a semiconductor device, a liquid crystal display device, etc. is produced by the so-called photolithography technique wherein a pattern, which is formed on a mask such as a reticle, is transferred onto a substrate such as a wafer which is coated with a photosensitive material such as a resist (photoresist). In order to transfer the pattern on the mask onto the substrate via a projection optical system in the photolithography step, those used as the exposure apparatus include, for example, an exposure apparatus (so-called stepper) of the reduction projection type of the step-and-repeat system and an exposure apparatus (so-called scanning stepper) of the reduction projection type of the step-and-scan system.

As for the exposure apparatus of this type, the wavelength of the exposure light has been shortened and the numerical aperture (NA) of the projection optical system has been increased (realize the large NA) in order to respond to such a request that the higher resolution (resolving power) is demanded year by year as the pattern becomes fine and minute in accordance with the realization of the high integration of the semiconductor device or the like. However, while the wavelength of the exposure light is shortened and NA is increased to then improve the resolution of the projection optical system, the depth of focus is consequently decreased and narrowed. Therefore, if such a situation is continued, then the depth of focus is too narrowed and it is feared that the focus margin might be insufficient during the exposure operation.

In view of the above, an exposure apparatus, which utilizes the liquid immersion method, has been developed. The liquid immersion method is a method that the exposure wavelength is substantially shortened and the depth of focus is widened as compared with those obtained in the air (see, for example, International Publication No. 99/49504). In the liquid immersion method, the exposure is performed in such a state that a liquid immersion area is formed by filling a space between the lower surface of the projection optical system and a surface of the substrate (substrate surface) with a liquid including water, organic solvents, etc. With this, the resolution can be improved and the depth of focus can be magnified about n times by utilizing the fact that the wavelength of the exposure light is 1/n-fold in the liquid as compared with the wavelength in the air (n represents the refractive index of the liquid, which is, for example, about 1.2 to 1.6).

### DISCLOSURE OF THE INVENTION

### Task to Be Solved by the Invention:

In a case that the exposure process is performed by using the liquid immersion method as described above, then the exposure is performed for the substrate while supplying the liquid from a predetermined or certain liquid supply mechanism to the liquid immersion area formed between the projection optical system and the substrate, and the liquid of the liquid immersion area is recovered by a predetermined or certain liquid recovery mechanism, for example, during the step-movement of the substrate. However, it is feared that a minute foreign matter (particles) including a resist residue, etc. might be gradually accumulated, during the exposure based on the liquid immersion method, on a portion (liquid contact portion) which comes into contact with the liquid, for example, on the flow passages for the liquid of the liquid supply mechanism, the liquid recovery mechanism, etc. There is such a possibility that the foreign matter, which is accumulated as described above, might enter into and mix with the liquid again during the exposure to be performed thereafter and might adhere to the surface of the substrate as the exposure objective, and the foreign matter might become a factor of the defect such as a shape deficiency or unsatisfactory shape, etc. of the pattern to be transferred.

Therefore, it is desirable that the foreign matter, accumulated on the liquid flow passages of the liquid supply mechanism, the liquid recovery mechanism etc., is efficiently removed by any method, for example, during a periodic maintenance for the exposure apparatus.
Taking the foregoing circumstances into consideration, an object of the present invention is to provide an efficient maintenance technique for the exposure apparatus for performing the exposure by the liquid immersion method.

Another object of the present invention is to provide an exposure technique and a technique for producing a device to which the maintenance technique is applicable with ease. Still another object of the present invention is to provide a cleaning or washing technique, an exposure technique, and a technique for producing a device, wherein it is possible to easily clean or wash a liquid contact portion which comes into contact with the liquid.

### Solution for the Task:

A first maintenance method according to the present invention is a maintenance method for an exposure apparatus which forms a liquid immersion space by filling, with a first liquid (1), a space between an optical member (2) and a substrate (P) held by a substrate stage (PH, etc.) and exposes the substrate with an exposure light (EL) via the optical member (2) and the first liquid, the maintenance method comprising: a moving step of arranging a movable stage (MST) which is movable independently from the substrate stage to be opposite to a liquid immersion space-forming member (30) which forms the liquid immersion space with the first liquid; and a cleaning step of cleaning the liquid immersion space-forming member by supplying a second liquid (1A) to a space between the liquid immersion space-forming member and the movable stage.

A first exposure method according to the present invention is an exposure method for forming a liquid immersion space by filling, with a first liquid (1), a space between an optical member (2) and a substrate (P) held by a substrate stage (PH, etc.) and exposing the substrate with an exposure light via the optical member (2) and the first liquid, the exposure method comprising: a moving step of arranging a movable stage (MST) to be opposite to a liquid immersion space-forming member (30) which forms the liquid immersion space with the first liquid by exchanging the substrate stage with the movable stage; and a cleaning step of cleaning the liquid immersion space-forming member by supplying a second liquid (1A) to a space between the liquid immersion space-forming member and the movable stage.

According to the first maintenance method and exposure method of the present invention, the second liquid is supplied to the liquid immersion space-forming member (nozzle member). Therefore, at least a part of the foreign matter, which is accumulated in the liquid immersion space-forming member when the exposure is performed in accordance with the liquid immersion method, can be removed together with the second liquid. In this procedure, the maintenance can be performed efficiently by using the movable stage exchanged with the substrate stage or the measuring stage.

A first exposure apparatus according to the present invention is an exposure apparatus which exposes a substrate (P) with an exposure light (EL) via an optical member (2) and a first liquid (1), the exposure apparatus comprising: a substrate stage (PH, etc.) which holds the substrate; a liquid immersion space-forming member (30) which forms a liquid immersion space by filling, with the first liquid (1), a space between the optical member and the substrate held by the substrate stage; a movable stage (MST) which is arranged to be opposite to the liquid immersion space-forming member when the substrate stage is exchanged with the movable stage; and a cleaning mechanism (62, 63A) at least a part of which is provided on the movable stage (MST) and which cleans the liquid immersion space-forming member by supplying a second liquid to a space between the liquid immersion space-forming member and the cleaning mechanism.

The first maintenance method or the exposure method of the present invention can be carried out by the first exposure apparatus of the present invention. A method for producing a device according to the present invention uses the first maintenance method, the first exposure method, or the first exposure apparatus of the present invention.

A second maintenance method according to the present invention is a maintenance method for an exposure apparatus which forms a liquid immersion space by filling a space between an optical member (2) and a substrate (P) with a first liquid (1) and exposes the substrate with an exposure light (EL) via the optical member (2) and the first liquid, the maintenance method comprising: a cleaning step of cleaning a liquid immersion space-forming member, which forms the liquid immersion space with the first liquid, by vibrating a second liquid in a predetermined space communicated with a passage port, for the first liquid, of the liquid immersion space-forming member (30).

According to the second maintenance method of the present invention, the second liquid is vibrated in the liquid immersion space-forming member, for example, in the nozzle member, to thereby make it possible to easily remove, together with the second liquid, at least a part of the foreign matter accumulated in the liquid immersion space-forming member when the exposure is performed in accordance with the liquid immersion method. Therefore, it is possible to efficiently perform the maintenance for the mechanism supplying and recovering the first liquid, including, for example, the liquid immersion space-forming member. A second exposure method of the present invention uses the second maintenance method of the present invention.

A third maintenance method according to the present invention is a maintenance method for an exposure apparatus which forms a liquid immersion space by filling a space between an optical member (2) and a substrate (P) with a first liquid (1) and exposes the substrate with an exposure light (EL) via the optical member (2) and the first liquid, the maintenance method comprising: a moving step of arranging a movable member (MST) to be opposite to a liquid immersion space-forming member (30) which forms the liquid immersion space with the first liquid; and a cleaning step of jetting a second liquid from the movable member toward a passage port, for the first liquid, of the liquid immersion space-forming member to clean the liquid immersion space-forming member.

According to the third maintenance method of the present invention, at least a part of the foreign matter, which is accumulated in the liquid immersion space-forming member when the exposure is performed in accordance with the liquid immersion method, can be easily removed together with the second liquid by jetting the second liquid to the liquid immersion space-forming member, for example, to the passage port of the nozzle member. With this, it is possible to efficiently perform the maintenance for the mechanism supplying and recovering the first liquid, including, for example, the liquid immersion space-forming member. A third exposure method of the present invention uses the third maintenance method of the present invention.

A second exposure apparatus according to the present invention is an exposure apparatus which exposes a substrate (P) with an exposure light (EL) via an optical member (2) and a first liquid (1), the exposure apparatus comprising: a liquid immersion space-forming member (30) which forms a liquid immersion space by filling a space between the optical member and the substrate with the first liquid; a liquid supply mechanism (26, 27) which supplies a second liquid into a predetermined space communicated with a passage port, for the first liquid, of the liquid immersion space-forming member; and a vibration device (267A, 268A) which vibrates the second liquid in the predetermined space.

A third exposure apparatus according to the present invention is an exposure apparatus which exposes a substrate (P) with an exposure light (EL) via an optical member (2) and a first liquid (1), the exposure apparatus comprising: a liquid immersion space-forming member (30) which forms a liquid immersion space by filling a space between the optical member and the substrate with the first liquid; a movable member (MST) which is arranged to be opposite to the liquid immersion space-forming member; and a jetting device (362A, 363A) which jets a second liquid from the movable member toward a passage port, for the first liquid, of the liquid immersion space-forming member so as to clean the liquid immersion space-forming member.

The second and third maintenance methods of the present invention can be carried out by the second and third exposure apparatuses of the present invention, respectively. The second or third exposure method of the present invention uses the second or third maintenance method of the present invention. A method for producing a device according to the present invention includes exposing a substrate by using the second or third exposure method or the second or third exposure apparatus of the present invention; developing (S204) the exposed substrate; and processing (S205) the developed substrate.

A fourth maintenance method according to the present invention is a maintenance method for an exposure apparatus which forms a liquid immersion space by filling a space between an optical member (2) and a substrate (P) with a first liquid and exposes the substrate with an exposure light (EL) via the optical member (2) and the first liquid, the maintenance method comprising: a moving step of arranging a movable member to be opposite to a liquid immersion space-forming member (30) which forms the liquid immersion space with the first liquid; and a cleaning step of cleaning the liquid immersion space-forming member by a flexible cleaning member (468) which is provided on the movable member. According to the fourth maintenance method of the present invention, it is possible to remove at least a part of the foreign matter tightly adhered to and accumulated on the liquid immersion space-forming member, for example, the nozzle member when the exposure is performed in accordance with the liquid immersion method, by performing brushing (cleaning) by the cleaning member. With this, it is possible to efficiently perform the maintenance. A fourth exposure method according to the present invention uses the fourth maintenance method of the present invention. A method for producing a device according to the present invention includes exposing (S204) a substrate by using the fourth exposure method of the present invention; developing (S204) the exposed substrate; and processing (S205) the developed substrate.

A fifth maintenance method according to the present invention is a maintenance method for an exposure apparatus which forms a liquid immersion space by filling a space between an optical member (2) and a substrate (P) with a first liquid and exposes the substrate with an exposure light (EL) via the optical member (2) and the first liquid, the maintenance method comprising: a liquid immersion step of arranging a movable member (PH, etc.) to be opposite to a liquid immersion space-forming member (30) which forms the liquid immersion space with the first liquid and supplying the first liquid onto the movable member; and a cleaning step of cleaning the liquid immersion space-forming member by using a gas supplied to surround the liquid immersion space during the exposure. According to the fifth maintenance method of the present invention, the liquid, into and with which minute bubbles generated by the gas entered and mixed, is supplied to the liquid immersion space-forming member, for example, to the nozzle member. Therefore, it is possible to remove at least a part of the foreign matter tightly adhered to and accumulated on the liquid immersion space-forming member when the exposure is performed in accordance with the liquid immersion method. Therefore, it is possible to perform the maintenance efficiently. A fifth exposure method according to the present invention uses the fifth maintenance method of the present invention. A method for producing a device according to the present invention includes exposing (S204) a substrate by using the fifth exposure method of the present invention; developing (S204) the exposed substrate; and processing (S205) the developed substrate.

A fourth exposure apparatus according to the present invention is an exposure apparatus which forms a liquid immersion space by filling a space between an optical member (2) and a substrate (P) with a first liquid (1) and exposes the substrate with an exposure light (EL) via the optical member (2) and the first liquid, the exposure apparatus comprising: a liquid immersion space-forming member (30) which forms the liquid immersion space with the first liquid; a movable member (MST) which is arranged to be opposite to the optical member (2); and a cleaning mechanism (470, 168A, 168B) which has a flexible cleaning member (468) arranged on the movable member and which cleans the liquid immersion space-forming member by moving the cleaning member relative to at least a part of the liquid immersion space-forming member while bringing the cleaning member and at least the part of the liquid immersion space-forming member into contact with each other.

A fifth exposure apparatus according to the present invention is an exposure apparatus which forms a liquid immersion space by filling a space between an optical member (2) and a substrate (P) with a first liquid (1) and exposes the substrate with an exposure light (EL) via the optical member (2) and the first liquid, the exposure apparatus comprising: a liquid immersion space-forming member (30) which forms the liquid immersion space with the first liquid; a gas supply mechanism (593, 594) which supplies a gas such that the gas surrounds the liquid immersion space during exposure of the substrate; a movable member (PH, etc.) which is arranged to be opposite to the optical member (2); a liquid supply section (10) which supplies the first liquid onto the movable member via the liquid immersion space-forming member; and a controller (CONT) which allows the gas supply mechanism to supply the gas to an area on the movable member to which the first liquid is supplied so as to clean the liquid immersion space-forming member.

The fourth and fifth maintenance methods or the exposure methods of the present invention can be carried out by the fourth and fifth exposure apparatuses of the present invention. A method for producing a device according to the present invention includes exposing (S204) a substrate by using the fourth or fifth exposure apparatus of the present invention; developing (S204) the exposed substrate; and processing (S205) the developed substrate.

A sixth maintenance method according to the present invention is a maintenance method for an exposure apparatus which exposes a substrate (P) with an exposure light (EL) via an optical member (2) and a first liquid (1), the maintenance method comprising: cleaning a liquid contact portion which comes into contact with the first liquid by a cleaning member at least a part of which is provided on a second movable member (MTB) different from a first movable member (PH, etc.) holding the substrate. A sixth exposure method according to the present invention uses the sixth maintenance method of the present invention. A method for producing a device according to the present invention includes exposing (S204) a substrate by using the sixth exposure method of the present invention; developing (S204) the exposed substrate; and processing (S205) the developed substrate.

A sixth exposure apparatus according to the present invention is an exposure apparatus which exposes a substrate (P) with an exposure light (EL) via an optical member (2) and a first liquid (1), the exposure apparatus comprising: a first movable member (PH) which holds the substrate; a second movable member (MTB) which is different from the first movable member; and a cleaning member at least a part of which is provided on the second movable member and which cleans a liquid contact portion which comes into contact with the first liquid.

A seventh exposure apparatus according to the present invention is an exposure apparatus which exposes a substrate (P) with an exposure light (EL) via an optical member (2) and a first liquid (1), the exposure apparatus comprising: a movable member (MTB) which is arranged to be opposite to the optical member; and a cleaning mechanism (470, etc.) at least a part of which is provided on the movable member and which cleans a liquid contact portion, which comes into contact with the first liquid, by moving a cleaning member relative to the liquid contact portion while bringing the cleaning member and the liquid contact portion into contact with each other. A method for producing a device according to the present invention includes exposing (S204) a substrate by using the sixth or seventh exposure apparatus of the present invention; developing (S204) the exposed substrate; and processing (S205) the developed substrate.

The parenthesized reference numerals, which are affixed to the predetermined elements of the present invention as defined above, correspond to members depicted in the drawings to illustrate an example of embodiment of the present invention. However, the respective reference numerals merely exemplify the elements of the present invention by way of example so that the present invention is understood more easily, and do not limit the present invention to any construction of the embodiment.

### BRIEF DESCRIPTION OF THE DRAWINGS

Fig. 1 shows a schematic construction of, with partial cutout, an exposure apparatus according to a first embodiment of the present invention.
Fig. 2 shows a perspective view of a nozzle member 30 shown in Fig. 1.
Fig. 3 shows a bottom view of the nozzle member shown in Fig. 2.
Fig. 4 shows, with partial cutout, a supply section and a recovery section for the cleaning liquid connected to a measuring stage MST shown in Fig. 1.
Fig. 5 shows a plan view of a substrate stage PST and the measuring stage MST shown in Fig. 1.
Fig. 6 is a plan view showing a process in which the measuring stage MST is moved to a bottom surface of a projection optical system PL, from the state shown in Fig. 5.
Fig. 7 shows sectional views illustrating the measuring table MTB and the nozzle member 30 to depict a cleaning step according to the first embodiment of the present invention, illustrating such situations that the maintenance method of the present invention is carried out in accordance with Figs. 7(A) to 7(D).
Fig. 8 shows, with partial cutout, a supply section and a recovery section for the cleaning liquid connected to a measuring stage MST according to a second embodiment of the present invention.
Fig. 9 shows a plan view of a substrate stage PST and the measuring stage MST according to the second embodiment of the present invention.
Fig. 10 is a plan view showing a process in which the measuring stage MST is moved to a bottom surface of a projection optical system PL, from the state shown in Fig. 9.
Fig. 11 shows sectional views illustrating the measuring table MTB and a nozzle member 30 to depict a cleaning step according to the second embodiment of the present invention, illustrating such situations that the maintenance method of the present invention is carried out in accordance with Figs. 11(A) to 11(D).
Fig. 12 shows, with partial cutout, a cleaning mechanism according to a third embodiment of the present invention.
Fig. 13 shows sectional views illustrating a measuring table MTB and a nozzle member 30 to depict a cleaning step according to the third embodiment of the present invention, illustrating such situations that the maintenance method of the present invention is carried out in accordance with Figs. 13(A) to 13(D).
Fig. 14 shows, with partial cutout, a brush mechanism and a recovery section for the cleaning liquid connected to a measuring stage MST according to a fourth embodiment of the present invention.
Fig. 15 shows a plan view of a substrate stage PST and the measuring stage MST according to the fourth embodiment of the present invention.
Fig. 16 is a plan view showing a process in which the measuring stage MST is moved to a bottom surface of a projection optical system PL, from the state shown in Fig. 15.
Fig. 17 shows sectional views illustrating the measuring table MTB and a nozzle member 30 to depict a cleaning step according to the fourth embodiment of the present invention, illustrating such situations that the maintenance method of the present invention is carried out in accordance with Figs. 17(A) to 17(D).
Fig. 18 shows, with partial cutout, a situation to clean the nozzle member 30 according to a first modification of the fourth embodiment of the present invention.
Fig. 19 shows, with partial cutout, a situation to clean the nozzle member 30 according to a second modification of the fourth embodiment of the present invention.
Fig. 20 shows, with partial cutout, main components of an exposure apparatus according to a fifth embodiment of the present invention.
Fig. 21 shows a plan view of a substrate stage, a measuring stage, etc. of an exposure apparatus according to a sixth embodiment of the present invention.
Fig. 22 shows a plan view of a substrate stage, a measuring stage, etc. of a modification of the sixth embodiment of the present invention.
Fig. 23 shows a flow chart illustrating an example of steps of producing a microdevice.

### Legend of reference numerals:

1: liquid, 2: optical element, 10: liquid supply mechanism, 11: liquid supply section, 13, 14: supply port, 20: liquid recovery mechanism, 21: liquid recovery section, 24: recovery port, 25: mesh filter, 26, 62: cleaning liquid supply section, 30: nozzle member, 267A, 267B: stirring bar, 268A, 268B: driving section, 60, 460, 660, 760: pool portion, 65: cleaning liquid recovery section, 468, 488, 488A: brush member, AR1: projection area, AR2: liquid immersion area, CONT: controller, EL: exposure light, EX: exposure apparatus, M: mask, P: substrate, PL: projection optical system, PST: substrate stage, MST: measuring stage, MTB: measuring table.

### BEST MODE FOR CARRYING OUT THE INVENTION

### First Embodiment

A preferred exemplary embodiment of the present invention will be explained below with reference to the drawings.

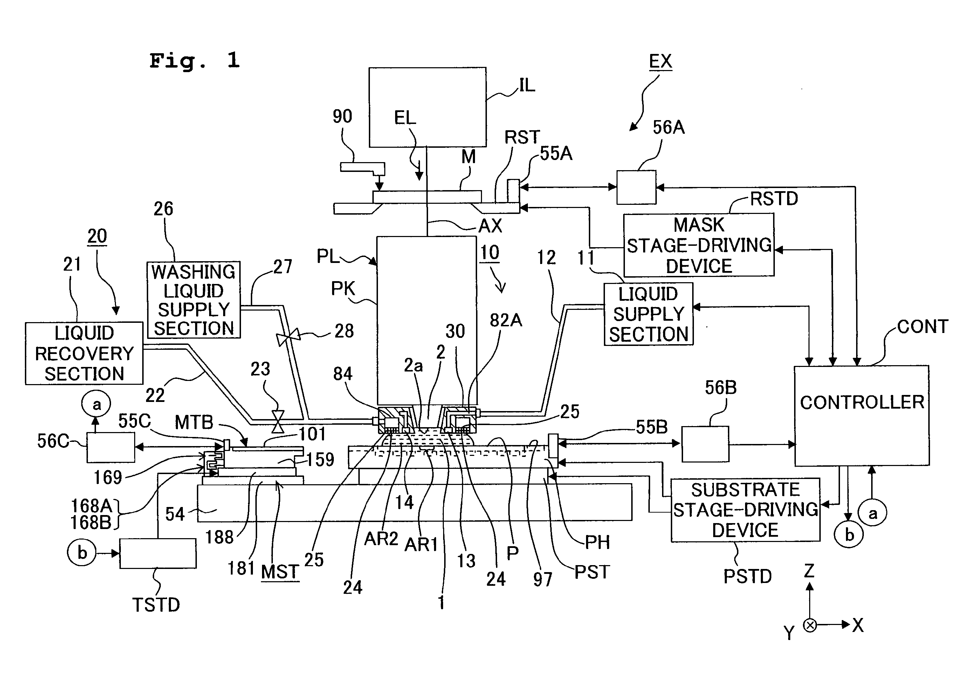

Fig. 1 shows a schematic construction of an exposure apparatus EX according to the first embodiment. With reference to Fig. 1, the exposure apparatus EX includes a mask stage RST which supports a mask M formed with a transferring pattern; a substrate stage PST which supports a substrate P as an exposure objective; an illumination optical system IL which illuminates, with an exposure light EL, the mask M supported by the mask stage RST; a projection optical system PL which projects an image of the pattern (pattern image) of the mask M illuminated with the exposure light EL onto a projection area AR1 on the substrate P supported by the substrate stage PST; a measuring stage MST which is formed with a reference mark for alignment, etc.; a controller CONT which integrally controls the operation of the entire exposure apparatus EX; and a liquid immersion system (liquid immersion mechanism) which is provided for the application of the liquid immersion method. The liquid immersion system of this embodiment includes a liquid supply mechanism 10 which supplies the liquid 1 onto the substrate P and onto the measuring stage MST, and a liquid recovery mechanism 20 which recovers the liquid 1 supplied onto the substrate P and onto the measuring stage MST.

The exposure apparatus EX forms a liquid immersion area AR2 (locally) in a part of an area on the substrate P including the projection area AR1 of the projection optical system PL or in the part of the area on the substrate P and a surrounding area therearound, with the liquid 1 supplied from the liquid supply mechanism 10 at least during a period in which the pattern image of the mask M is transferred onto the substrate P. Specifically, the exposure apparatus EX adopts the local liquid immersion system in which a space, between an optical element (for example, a lens having a substantially flat bottom surface or a plane-parallel) 2 arranged at the terminal end on the side of the image plane (image plane side) of the projection optical system PL and the surface of the substrate P arranged on the image plane side, is filled with the liquid 1; and in which the substrate P is exposed with the exposure light EL passing through the mask M, via the projection optical system PL and the liquid 1 between the projection optical system PL and the substrate P, so that the pattern of the mask M is transferred to and exposed on the substrate P. In this embodiment, the liquid immersion exposure is performed by using a liquid immersion space-forming member (including, for example, a nozzle member 30) which forms the liquid immersion space including the optical path space for the exposure light EL radiated from the projection optical system PL.

In this embodiment, an explanation will be made as exemplified by a case using, as the exposure apparatus EX, a scanning type exposure apparatus (so-called scanning stepper) in which the substrate P is exposed with the pattern formed on the mask M while synchronously moving the mask M and the substrate P in a predetermined or certain scanning direction. The following description will be made assuming that the Z axis extends in parallel to the optical axis AX of the projection optical system PL, the X axis extends in a synchronous movement direction (scanning direction) of the mask M and the substrate P in a plane perpendicular to the Z axis, and the Y axis extends in a direction perpendicular to the scanning direction (non-scanning direction). The directions of rotation (inclination) about the X axis, the Y axis, and the Z axis are designated as the θX, θY, and θZ directions respectively. In this description, the term "substrate" includes those obtained by coating a base material including, for example, a semiconductor wafer such as a silicon wafer with a photosensitive material (hereinafter appropriately referred to as "resist"), and also includes those obtained by coating the base material with various films including, for example, a protective film (top coat film) distinctly from the photosensitive film. The mask includes a reticle on which a device pattern to be subjected to the reduction projection onto the substrate is formed. For example, the mask is obtained such that a predetermined pattern is formed by using a light-shielding film such as chromium on a transparent plate member such as a glass plate. The transmission type mask is not limited to a binary mask in which the pattern is formed with the light-shielding film, and also includes, for example, a phase shift mask of the spatial frequency modulation type, the half tone type, or the like. In this embodiment, those usable as the substrate P may be obtained, for example, such that a disk-shaped semiconductor wafer, which has a diameter of about 200 mm to 300 mm, is coated with the resist (photoresist) as the photosensitive material by an unillustrated coater/developer to provide a predetermined thickness (for example, about 200 nm), and a surface of the resist is coated with an antireflection film or a top coat film, if necessary.

At first, the illumination optical system IL illuminates, with the exposure light EL, the mask M supported by the mask stage RST. The illumination optical system IL includes an optical integrator which uniformizes the illuminance of the light flux radiated from an unillustrated exposure light source; a condenser lens which collects the exposure light EL from the optical integrator; a relay lens system; a variable field diaphragm which defines the illumination area on the mask M brought about by the exposure light EL to have a slit-shaped form; and the like. The predetermined illumination area on the mask M is illuminated with the exposure light EL having the uniform illuminance distribution by the illumination optical system IL. Those used as the exposure light EL irradiated from the illumination optical system IL include, for example, emission lines (for example, i-ray) in the ultraviolet region radiated from a mercury lamp, etc.; far ultraviolet light beams (DUV light beams) such as the KrF excimer laser beam (wavelength: 248 nm); vacuum ultraviolet light beams (VUV light beams) such as the ArF excimer laser beam (wavelength: 193 nm) and the F₂ laser beam (wavelength: 157 nm); etc. In this embodiment, the ArF excimer laser beam is used as the exposure light EL.

The mask stage RST supports the mask M. The mask stage RST is two-dimensionally movable in a plane, on an unillustrated mask base, perpendicular to the optical axis AX of the projection optical system PL, i.e., in the XY plane, and it is finely rotatable in the θZ direction. The mask stage RST is driven, for example, by a mask stage-driving device RSTD such as a linear motor. The mask stage-driving device RSTD is controlled by the controller CONT. A reflecting mirror 55A is provided on the mask stage RST. A laser interferometer 56A is provided at a position opposite to or facing the reflecting mirror 55A. In reality, the laser interferometer 56A constitutes a laser interferometer system having three or more length-measuring axes. The position in the two-dimensional direction and the angle of rotation of the mask stage RST (mask M) are measured in real-time by the laser interferometer 56A. An obtained result of the measurement is outputted to the controller CONT. The controller CONT drives the mask stage-driving device RSTD based on the result of the measurement to thereby move or position the mask M supported by the mask stage RST. The reflecting mirror 55A is not limited to only the plane mirror, and may include a corner cube (retroreflector). Alternatively, for example, it is also allowable to use a reflecting surface formed by mirror-finishing an end surface (side surface) of the mask stage RST, instead of using the reflecting mirror 55A.

The projection optical system PL projects the pattern of the mask M onto the substrate P to perform the exposure at a predetermined projection magnification β (β represents the reduction magnification, which is, for example, 1/4, 1/5 or the like). The projection optical system PL is constructed by a plurality of optical elements including the optical element 2 which is provided at the terminal end (end portion) on the side of the substrate P (image plane side of the projection optical system PL). The optical elements are supported by a barrel PK. The projection optical system PL is not limited to the reduction system, and may be any one of the 1x magnification system and the magnifying system. The optical element 2, which is disposed at the end portion of the projection optical system PL, is provided detachably (exchangeably) with respect to the barrel PK. The liquid 1 of the liquid immersion area AR2 comes into contact with the optical element 2. Although not shown, the projection optical system PL is provided on a barrel surface plate supported by three support columns via an anti-vibration mechanism. However, as disclosed, for example, in International Publication No. 2006/038952, the projection optical system PL may be supported in a hanging manner, for example, on an unillustrated main frame member which is arranged over or above the projection optical system PL or on the mask base described above.

In this embodiment, pure or purified water is used for the liquid 1. Not only the ArF excimer laser beam but also the far ultraviolet light beam (DUV light beam) such as the KrF excimer laser beam and the emission line radiated from a mercury lamp, etc. is also transmissive through pure water. The optical element 2 is formed of calcium fluoride (CaF₂). Calcium fluoride has a high affinity for water. Therefore, it is possible to bring the liquid 1 into tight contact with the substantially entire surface of a liquid contact surface 2a of the optical element 2. The optical element 2 may be silica glass which has a high affinity for water.

The resist of the substrate P is, as an example, a liquid-repellent resist which repels the liquid 1. As described above, the resist may be coated with the top coat for the protection, if necessary. In this embodiment, the property to repel the liquid 1 is called "liquid repellence". In a case that the liquid 1 is pure water, the liquid repellence means the water repellence. A substrate holder PH, which holds the substrate P, for example, by the vacuum attraction, is fixed to the upper portion of the substrate stage PST. The substrate stage PST is provided with a Z stage which controls the position in the Z direction (focus position) and the angles of inclination in the θX and θY directions of the substrate holder PH (substrate P), and an XY stage which is movable while supporting the Z stage. The XY stage is placed over a guide surface (surface substantially parallel to the image plane of the projection optical system PL) which is parallel to the XY plane on the base 54, for example, with an air bearing (gas bearing) intervening therebetween so that the XY stage is movable in the X direction and the Y direction. The substrate stage PST (Z stage and XY stage) is driven by a substrate stage-driving device PSTD such as a linear motor. The substrate stage-driving device PSTD is controlled by the controller CONT. In this embodiment, the substrate holder is formed on a table which is movable in the Z, θX, and θY directions, and these components are collectively referred to as "substrate holder PH". The table and the substrate holder may be constructed separately or distinctly, and the substrate holder may be fixed to the table, for example, by the vacuum attraction. The Z stage may be constructed, for example, by a substrate holder PH (table), and an actuator (for example, a voice coil motor) which drives the substrate holder PH in the Z, θX, and θY directions.

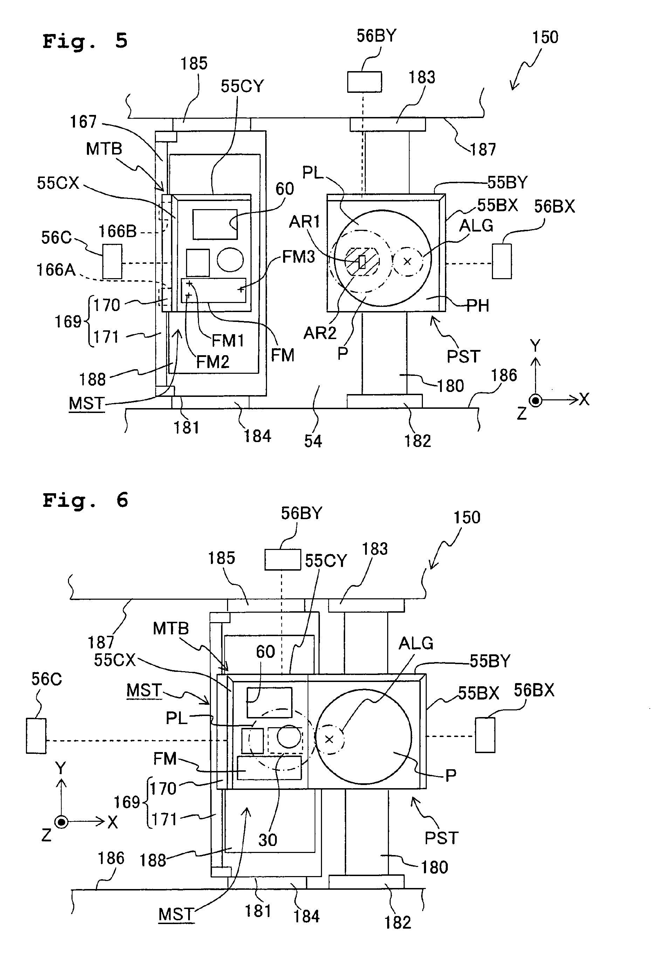

A reflecting mirror 55B is provided on the substrate holder PH on the substrate stage PST. A laser interferometer 56B is provided at a position opposite to or facing the reflecting mirror 55B. In reality, as shown in Fig. 5, the reflecting mirror 55B is constructed of an X axis reflecting mirror 55BX and a Y axis reflecting mirror 55BY. The laser interferometer 56B is also constructed of an X axis laser interferometer 56BX and a Y axis laser interferometer 56BY. With reference to Fig. 1 again, the position in the two-dimensional direction and the angle of rotation of the substrate holder PH (substrate P) on the substrate stage PST are measured in real-time by the laser interferometer 56B. An obtained result of the measurement is outputted to the controller CONT. The controller CONT drives the substrate stage-driving device PSTD based on the result of the measurement to thereby move or position the substrate P supported by the substrate stage PST. The laser interferometer 56B may be also capable of measuring the information about the position in the Z axis direction and the rotation in the θX and θY directions of the substrate stage PST; and details thereof are disclosed, for example, in Published Japanese Translation of PCT International Publication for Patent Application No. 2001-510577 (corresponding to International Publication No. 1999/28790). A reflecting surface, which is formed by mirror-finishing, for example, a side surface of the substrate stage PST or the substrate holder PH, may be used instead of using the reflecting mirror 55B.

An plate portion 97, which is annular and flat and liquid-repellent, is provided on the substrate holder PH so that the substrate P is surrounded thereby. The liquid-repelling process or treatment includes, for example, the coating process using a material having the liquid repellence. The material having the liquid repellence includes, for example, fluorine-based resin materials such as polytetrafluoroethylene (Teflon (trade name)), acrylic resin materials, silicon-based resin materials, and synthetic resin materials such as polyethylene. The thin film for the surface treatment may be a single layer film or a film formed of a plurality of layers. The upper surface of the plate portion 97 is a flat surface which has a height approximately same as that of the surface of the substrate P held by the substrate holder PH. In this case, a gap of about 0.1 to 1 mm is provided between the edge of the substrate P and the plate portion 97. However, in this embodiment, the resist, with which the substrate P is coated, is liquid-repellent, and the liquid 1 has the surface tension. Therefore, the liquid 1 is hardly allowed to inflow into the gap. Even in a case that a portion, which is located in the vicinity of the circumferential edge of the substrate P, is exposed, it is possible to retain the liquid 1 between the plate portion 97 and the projection optical system PL. It is also allowable that the substrate holder PH is provided with a sucking device (not shown) in order that the liquid 1, which is allowed to inflow into the gap between the plate portion 97 and the substrate P, is discharged to the outside. Therefore, it is not necessarily indispensable that the resist (or the top coat) of the substrate P is liquid-repellent. In this embodiment, the plate portion 97 is provided detachably (exchangeably) with respect to the substrate holder PH. However, the upper surface of the substrate holder PH, which surrounds the substrate P, may be subjected to the liquid-repelling process to form the flat surface.

### Liquid Supply and Recovery Mechanisms

Next, the liquid supply mechanism 10 shown in Fig. 1 is provided to supply the predetermined liquid 1 onto the substrate P. The liquid supply mechanism 10 includes a liquid supply section 11 which is capable of feeding the liquid 1, and a supply tube 12 which has one end connected to the liquid supply section 11. The liquid supply section 11 is provided with a tank for accommodating the liquid 1, a filter section, a pressurizing pump, etc. It is not necessarily indispensable that the liquid supply mechanism 10 is provided with all of the tank, the filter section, the pressurizing pump, etc.; and at least a part or parts thereof may be substituted, for example, with an equipment of the factory or the like in which the exposure apparatus EX is installed.

The liquid recovery mechanism 20 is provided to recover the liquid 1 supplied onto the substrate P. The liquid recovery mechanism 20 includes a liquid recovery section 21 which is capable of recovering the liquid 1, a recovery tube 22 which has one end connected to the liquid recovery section 21, a supply tube 27 which is connected to the recovery tube 22, and a cleaning liquid supply section 26 which is connected to an end of the supply tube 27 to supply a predetermined or certain cleaning liquid. Valves 23, 28 are provided at intermediate positions of the recovery tube 22 and the supply tube 27, respectively. The liquid recovery section 21 is provided with, for example, a vacuum system (sucking device) such as a vacuum pump, and a tank for accommodating the recovered liquid 1. The cleaning liquid supply section 26 is provided with a tank for accommodating the cleaning liquid, a pressurizing pump, etc. By closing the valve 23 disposed on the side of the recovery tube 22 and by opening the valve 28 disposed on the side of the supply tube 27, the cleaning liquid can be supplied from the cleaning liquid supply section 26 via the supply tube 27 to the recovery tube 22. It is not necessarily indispensable that the liquid recovery mechanism 20 is provided with all of the vacuum system, the tank, etc.; and at least a part or parts thereof may be substituted, for example, with an equipment of the factory or the like in which the exposure apparatus EX is installed.

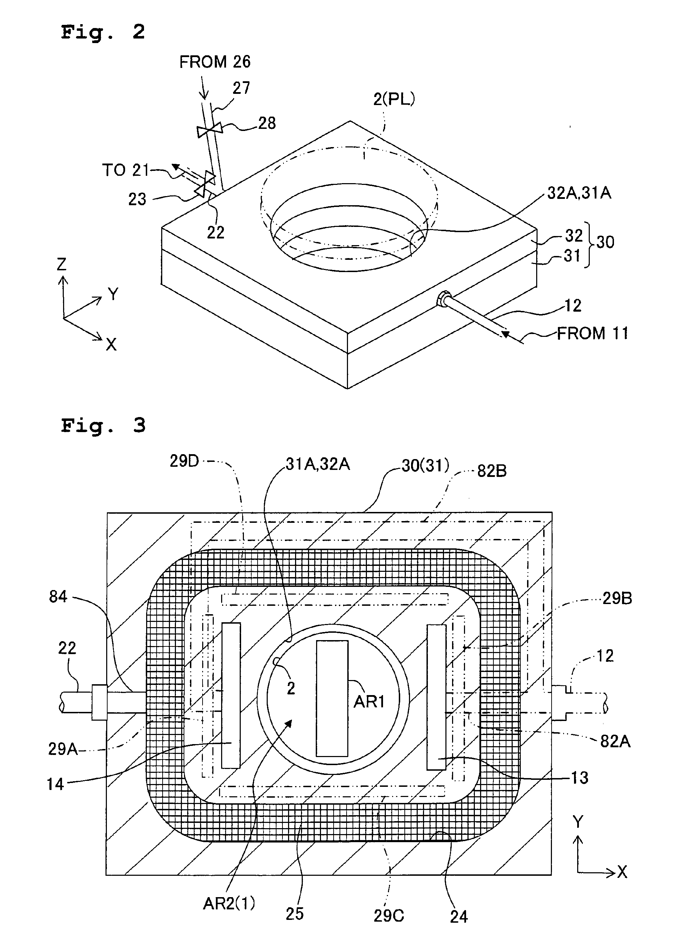

Those usable as the cleaning liquid include a mixture liquid of thinner and water as the liquid distinct from the liquid 1, γ-butyrolactone, any solvent such as isopropyl alcohol (IPA), etc. However, it is also possible to use the liquid 1 itself as the cleaning liquid. For example, in a case that the liquid 1 itself is used as the cleaning liquid, the liquid supply section 11 can be also used as the cleaning liquid supply section. Therefore, it is not necessarily indispensable to provide the cleaning liquid supply section 26 and the supply tube 27. The supply tube 27, which extends from the cleaning liquid supply section 26, can be also connected to the supply tube 12 which is communicated with the liquid supply section 11. In this case, the cleaning liquid may be supplied to the liquid immersion area (liquid immersion space) independently from the supply flow passage of the liquid 1 (for example, the supply tube 12). The nozzle member 30 is arranged as a flow passage-forming member in the vicinity of the optical element 2 disposed at the terminal end of the projection optical system PL. The nozzle member 30 is an annular member which is provided to surround the circumference of the optical element 2, at a position over or above the substrate P (substrate stage PST). The nozzle member 30 is supported by a column mechanism (not shown) via an unillustrated support member. The nozzle member 30 is provided with a first supply port 13 and a second supply port 14 (see Fig. 3) which are arranged to be opposite to or to face the surface of the substrate P in a state that the projection area AR1 of the projection optical system PL is on the substrate P. The nozzle member 30 has supply flow passages 82A, 82B (see Fig. 3) formed in the inside thereof. One end of the supply flow passage 82A is connected to the first supply port 13, and the second supply port 14 is connected via the supply flow passage 82B to an intermediate portion of the supply flow passage 82A (see Fig. 3). The other end of the supply flow passage 82A is connected to the liquid supply section 11 via the supply tube 12. Further, the nozzle member 30 is provided with a recovery port 24 (see Fig. 3) which has a rectangular frame-shaped form and which is arranged to be opposite to or face the surface of the substrate P.

Fig. 2 is a perspective view schematically showing the nozzle member 30. As shown in Fig. 2, the nozzle member 30 is the annular member which is provided to surround the circumference of the optical element 2 at the terminal end of the projection optical system PL. As an example, the nozzle member 30 is provided with a first member 31, and a second member 32 which is arranged on the upper portion of the first member 31. Each of the first and second members 31, 32 is a plate-shaped member, and the first and second members 31, 32 have through-holes 31A, 32A respectively which are formed at central portions thereof in which the projection optical system PL (optical element 2) can be arranged.

Fig. 3 shows a bottom view of the first member 31 disposed at the lower stage of the nozzle member 30 shown in Fig. 2. In Fig. 3, the supply flow passages 82A, 82B formed in the second member 32 disposed on the first member 31 and the supply tube 12 connected to the supply flow passage 82A are depicted by two-dot chain lines. The first member 31 of the nozzle member 30 is provided with the first supply port 13 which is formed on a side in the +X direction of the optical element 2 of the projection optical system PL and which supplies the liquid 1 onto the substrate P, and the second supply port 14 which is formed on a side in the -X direction of the optical element 2 and which supplies the liquid 1 onto the substrate P. The supply ports 13, 14 are arranged to interpose the projection area AR1 therebetween in the X direction (scanning direction of the substrate P). Each of the supply ports 13, 14 is a through-hole which penetrates through the first member 31 and which has a rectangular shape that is long in the Y direction. However, it is also allowable to adopt, for example, a circular arc-shaped form which is spread outwardly from the center of the projection area AR1.

Further, the first member 31 is formed with a frame-shaped recovery port 24 which is rectangular (or may be circular, etc.) and which is arranged to surround the optical element 2 of the projection optical system PL (projection area AR1), and a recovery flow passage 84 which makes communication between the recovery port 24 and the recovery tube 22. The recovery port 24 is a groove-shaped recess formed on the bottom surface of the first member 31 so that the recovery port 24 is opposite to or facing the substrate P, and the recovery port 24 is provided on the outer side of the supply ports 13, 14 with respect to the optical element 2. The gap between the substrate P and the supply ports 13, 14 and the gap between the substrate P and the recovery port 24 are provided substantially identically. A mesh filter 25, which is a porous member having a large number of small holes formed in a mesh form, is fitted to cover the recovery port 24. The liquid immersion area AR2, which is to be filled with the liquid 1, is formed inside an area which is substantially rectangular (or may be circular, etc.) and which is surrounded by the recovery port 24 to include the projection area AR1. Further, the liquid immersion area AR2 is formed locally on a part of the surface of the substrate P (or in a form to include a part of the surface of the substrate P) during the scanning exposure. The nozzle member (flow passage-forming member) 30 fills the space between the optical element 2 and the substrate P with the liquid 1 to form the local liquid immersion space (corresponding to the liquid immersion area AR2) including the optical path space for the exposure light EL. Therefore, the nozzle member (flow passage-forming member) 30 is referred to, for example, as "liquid immersion space-forming member" or "confinement member" as well.

Each of the first member 31 and the second member 32 of the nozzle member 30 shown in Fig. 2 and the mesh filter 25 shown in Fig. 3 is formed of a liquid-attractive material which has a relatively high affinity for the liquid 1, for example, stainless steel (SUS) or titanium. Therefore, with reference to Fig. 1, the liquid 1 in the liquid immersion area AR2 is allowed to pass through the mesh filter 25 of the recovery port 24 provided on the nozzle member 30, and then the liquid 1 is smoothly recovered by the liquid recovery section 21 via the recovery flow passage 84 and the recovery tube 22. In this process, any foreign matter, which is included in the foreign matter such as the resist residue or the like and which is larger than the meshes of the mesh filter 25 remains on the surface of the mesh filter 25.

With reference to Fig. 3, the liquid recovery port 24 of this embodiment has the rectangular or circular frame-shaped form. However, instead of this construction, as depicted by two-dot chain lines, the following construction is also available. That is, it is allowable that the recovery port is constructed by using two recovery ports 29A, 29B which are rectangular (or may be circular arc-shaped, etc.) and which are arranged to interpose the supply ports 13, 14 in the X direction and two recovery ports 29C, 29D which are rectangular (or may be circular arc-shaped, etc.) and which are arranged to interpose the optical element 2 in the Y direction; and that the mesh filter is arranged on each of the recovery ports 29A to 29D. The number of the recovery ports 29A to 29D is arbitrary. For example, as disclosed in International Publication No. 2005/122218, the recovery ports 29A to 29D and the recovery port 24 may be used in a duplicate manner to recover the liquid 1 in the liquid immersion area AR2. Further, the mesh filter may be also arranged on each of the recovery ports 13, 14 in order to prevent any foreign matter in the liquid immersion area AR2 from entering into the inside of the nozzle member 30. On the contrary, for example, in a case that the possibility of the adhesion of the foreign matter to the inside of the recovery tube 22 is low, it is not necessarily indispensable to provide the mesh filter 25.

The nozzle member 30 used in the embodiment described above is not limited to the structure described above. For example, it is also possible to use flow passage-forming members or the like described, for example, in European Patent Application Publication No. 1420298, International Publication Nos. 2004/055803, 2004/057589, and 2004/057590, and International Publication No. 2005/029559 (corresponding to United States Patent Application Publication No. 2006/0231206).
In this embodiment, the liquid supply ports 13, 14 and the recovery port 24 are provided on the same nozzle member 30. However, the supply ports 13, 14 and the recovery port 24 may be provided on distinct or different members (nozzle member, etc.). For example, only the supply port may be provided on any distinct member. Alternatively, only the recovery port may be provided on any distinct member. Further, for example, as disclosed in International Publication No. 2005/122218, a second recovery port (nozzle) for recovering the liquid may be provided outside the nozzle member 30. Further, with reference to Fig. 1, the supply ports 13, 14 may be communicated with different and distinct liquid supply sections, respectively, and the liquid 1 may be supplied from the supply ports 13, 14 to the liquid immersion area AR2 in a state that the supply amounts from the supply ports 13, 14 can be controlled independently from each other.

It is also allowable that the liquid supply ports 13, 14 are not arranged to be opposite to the substrate P. Further, the nozzle member 30 of this embodiment has the lower surface which is set to be arranged nearer to the image plane side (substrate side) as compared with the lower end surface of the projection optical system PL. However, the lower surface of the nozzle member 30 may be set at a height (Z position) approximately same as that of the lower end surface (light-exit surface) of the projection optical system PL. A part (lower end portion) of the nozzle member 30 may be provided to extend crawlingly until arrival at a position under the projection optical system PL (optical element 2) so that the exposure light EL is not shielded or blocked.

As described above, the nozzle member 30 forms a part of the liquid supply mechanism 10 and a part of the liquid recovery mechanism 20. That is, the nozzle member 30 is a part of the liquid immersion system. On the other hand, the valves 23, 28, which are provided for the recovery tube 22 and the supply tube 27, open/close the flow passages of the recovery tube 22 and the supply tube 27 respectively, and the operations of the valves 23, 28 are controlled by the controller CONT. The liquid recovery section 21 is capable of sucking and recovering the liquid 1 from the liquid immersion area AR2 via the recovery port 22 during the period in which the flow passage of the recovery tube 22 is open. When the flow passage of the recovery tube 22 is closed by the valve 23 in a state that the valve 28 is closed, the sucking recovery of the liquid 1 via the recovery port 24 is stopped. Afterwards, by opening the valve 28, it is possible to allow the cleaning liquid to flow through the recovery port 24 of the nozzle member 30 from the cleaning liquid supply section 26 via the supply tube 27, the recovery tube 22, and the mesh filter 25.

A part or parts of the liquid immersion system, for example, at least the nozzle member 30 may be supported in a hanging manner on the main frame (including the barrel surface plate described above) for retaining or holding the projection optical system PL, or a part or parts of the liquid immersion system may be provided on any frame member distinct from the main frame. Alternatively, in a case that the projection optical system PL is supported in the hanging manner as described above, the nozzle member 30 may be supported in a hanging manner integrally with the projection optical system PL. Alternatively, the nozzle member 30 may be provided on a measuring frame supported in a hanging manner independently from the projection optical system PL. In the case of the latter, it is also allowable that the projection optical system PL is not supported in the hanging manner.

With reference to Fig. 1, the liquid supply operations of the liquid supply section 11 and the cleaning liquid supply section 26 are controlled by the controller CONT. The controller CONT is capable of independently controlling the liquid supply amounts per unit time to be supplied onto the substrate P by the liquid supply section 11 and the cleaning liquid supply section 26 respectively. The liquid 1, fed from the liquid supply section 11, is supplied onto the substrate P from the supply ports 13, 14 (see Fig. 3) provided on the lower surface of the nozzle member 30 to be opposite to the substrate P, via the supply tube 12 and the supply flow passages 82A, 82B of the nozzle member 30.

The liquid recovery operation of the liquid recovery section 21 is controlled by the controller CONT. The controller CONT is capable of controlling the liquid recovery amount per unit time to be recovered by the liquid recovery section 21. The liquid 1 on the substrate P, recovered via the mesh filter 25 from the recovery port 24 provided on the lower surface of the nozzle member 30 to be opposite to the substrate P, is recovered by the liquid recovery section 21 via the recovery tube 22 and the recovery flow passage 84 of the nozzle member 30.

### Measuring Stage

With reference to Fig. 1, the measuring stage MST includes an X stage 181 which has an oblong shape long in the Y direction and which is driven in the X direction (scanning direction); a leveling table 188 which is placed thereon, for example, with an air bearing intervening therebetween; and a measuring table MTB which serves as a measuring unit arranged on the leveling table 188. As an example, the measuring table MTB is placed on the leveling table 188 with an air bearing intervening therebetween. However, the measuring table MTB and the leveling table 188 can be integrated into one body as well. The X stage 181 is placed on the base 54 movably in the X direction, for example, with an air bearing intervening therebetween.

Fig. 5 shows a plan view of the substrate stage PST and the measuring stage MST shown in Fig. 1. With reference to Fig. 5, X axis stators 186, 187, each of which includes a plurality of permanent magnets arranged in a predetermined arrangement in the X direction on the inner surface, are installed in parallel to the X axis so as to interpose the base 54 in the Y direction (non-scanning direction) between the X axis stators 186 and 187. A Y axis slider 180 is arranged movably in the X direction substantially in parallel to the Y axis, between the stators 186, 187 via movers 182, 183 which include coils respectively. The substrate stage PST is arranged movably in the Y direction along the Y axis slider 180. A Y axis linear motor, which drives the substrate stage PST in the Y direction, is constructed by movers included in the substrate stage PST and stators (not shown) on the Y axis slider 180. A pair of X axis linear motors, which drive the substrate stage PST in the X direction, are constructed by the movers 182, 183 and the stators 186, 187 corresponding thereto respectively. The X axis and Y axis linear motors, etc. constitute the substrate stage-driving device PSTD shown in Fig. 1.

On the other hand, an X stage 181 of the measuring stage MST is arranged movably in the X direction between stators 186, 187 via movers 184, 185 including coils respectively. A pair of X axis linear motors, which drive the measuring stage MST in the X direction, are constructed by the movers 184, 185 and the stators 186, 187 corresponding thereto respectively. The X axis linear motors, etc. are represented by the measuring stage-driving device TSTD in Fig. 1.

With reference to Fig. 5, a stator 167 which has a "]"-shaped cross-sectional form and in which a plurality of permanent magnets are arranged to generate the uniform magnetic field in the Z direction, to be opposite to or facing the inner surface and a stator 171 which has a flat plate-shaped form and which includes a coil wound (arranged) substantially along the X axis are successively fixed to an end of the X stage 181 in the -X direction so that the stators 167, 171 are disposed substantially in parallel to the Y axis and are stacked in the Z direction. Movers 166A, 166B, which include coils wound (arranged) along the Y axis respectively, are fixed at two positions respectively, the two position being separated in the Y direction on the measuring table MTB so that the movers 166A and 166B are arranged in the stator 167 disposed at the lower position. A mover 170, which has a "]"-shaped cross-sectional form and in which a plurality of permanent magnets are arranged in a predetermined arrangement in the Y direction, is fixed to the measuring table MTB so that the stator 171 disposed at the upper position is interposed in the Z direction. X axis voice coil motors 168A, 168B (see Fig. 1), which drive the measuring table MTB in the X direction and the θZ direction in minute amounts with respect to the X stage 181 respectively, are constructed by the movers 166A, 166B and the stator 167 disposed at the lower position. A Y axis linear motor 169, which drives the measuring table MTB in the Y direction with respect to the X stage 181, is constructed by the mover 170 and the stator 171 disposed at the upper position.

An X axis reflecting mirror 55CX and a Y axis reflecting mirror 55CY are fixed in the -X direction and the +Y direction respectively on the measuring table MTB. An X axis laser interferometer 56C is arranged to be opposite to or face the reflecting mirror 55CX in the -X direction. The reflecting mirrors 55CX, 55CY are represented by the reflecting mirror 55C in Fig. 1. The laser interferometer 56C is a multi-axis laser interferometer. The position in the X direction and the angle of rotation in the θZ direction of the measuring table MTB are always measured by the laser interferometer 56C. Instead of using the reflecting mirrors 55CX, 55CY, it is allowable to use, for example, a reflecting surface, which is formed by mirror-finishing a side surface of the measuring stage MST, etc.

On the other hand, with reference to Fig. 5, the laser interferometer 56BY, which is provided to measure the position in the Y direction, is commonly used for the substrate stage PST and the measuring stage MST. That is, the optical axes of the two X axis laser interferometers 56BX, 56C pass through the center of the projection area AR1 of the projection optical system PL (coincident with the optical axis AX shown in Fig. 1 in this embodiment), and the optical axes are parallel to the X axis. The optical axis of the Y axis laser interferometer 56BY passes through the center of the projection area (optical axis AX), and the optical axis is parallel to the Y axis. Therefore, usually, when the substrate stage PST is moved to the position under or below the projection optical system PL in order to perform the scanning exposure, then the laser beam of the laser interferometer 56BY is irradiated onto the reflecting mirror 55BY of the substrate stage PST, and the position of the substrate stage PST (substrate P) in the Y direction is measured by the laser interferometer 56BY. When the measuring table MTB of the measuring stage MST is moved to the position under or below the projection optical system PL in order to measure, for example, the image formation characteristic of the projection optical system PL, then the laser beam of the laser interferometer 56BY is irradiated onto the reflecting mirror 55CY of the measuring table MTB, and the position of the measuring table MTB in the Y direction is measured by the laser interferometer 56BY. Accordingly, the positions of the substrate stage PST and the measuring table MTB can be always measured highly accurately, with the reference of the center of the projection area of the projection optical system PL as a reference. Further, it is possible to decrease the number of laser interferometers which are highly accurate but expensive, thereby making it possible to reduce the production cost.

Linear encoders of the optical system, etc. (not shown) are arranged along the Y axis linear motor for the substrate stage PST and the Y axis linear motor 169 for the measuring table MTB. The position in the Y direction of the substrate stage PST or the measuring table MTB is measured by each of the linear encoders during a period in which the laser beam of the laser interferometer 56BY is not irradiated onto the reflecting mirror 55BY or 55CY.

With reference to Fig. 1 again, the position in the two-dimensional direction and the angle of rotation of the measuring table MTB are measured by the laser interferometer 56C and the laser interferometer 56BY shown in Fig. 5 (or the linear encoder). An obtained result of the measurement is outputted to the controller CONT. The controller CONT drives the measuring stage-driving device TSTD, the linear motor 169, and the voice coil motors 168A, 168B based on the measurement result, to thereby move or position the measuring table MTB of the measuring stage MST.

The leveling table 188 is provided with three Z axis actuators each of which is capable of controlling the position in the Z direction, for example, in accordance with an air cylinder or voice coil motor system. Usually, the position in the Z direction and the angles in the θX direction and the θY direction of the measuring table MTB are controlled by the leveling table 188 so that the upper surface of the measuring table MTB is focused with respect to the image plane of the projection optical system PL. For this purpose, an autofocus sensor (not shown) is provided in the vicinity of the nozzle member 30 in order to measure the position of a detection objective surface such as the upper surface of the substrate P disposed in the projection area AR1 and in the vicinity of the projection area AR1. The controller CONT controls the operation of the leveling table 188 based on the measured value obtained by the autofocus sensor. Further, although not shown, an actuator is also provided in order that the position of the leveling table 188 in the X direction, the Y direction, and the θZ direction with respect to the X stage 181 is maintained at a predetermined position.

The autofocus sensor also detects the information about the inclination in the θX and θY directions (angle of rotation) by measuring the position information in the Z direction about the detection objective surface at a plurality of measuring points thereof respectively. At least a part or parts of the plurality of measuring points may be defined in the liquid immersion area AR2 (or in the projection area AR1). Alternatively, all of the plurality of measuring points may be defined outside the liquid immersion area AR2. Further, for example, when the laser interferometers 56B, 56C are capable of measuring the position information in the Z axis, θX, and θY directions about the detection objective surface, then it is also allowable that the autofocus sensor is not provided for the purpose of making it possible to measure the position information in the Z direction during the exposure operation of the substrate P. It is also allowable that the position of the detection objective surface is controlled in relation to the Z axis, θX, and θY directions by using the measurement results of the laser interferometers 55B, 55C at least during the exposure operation.

The measuring table MTB of this embodiment is provided with measuring devices (measuring members) for performing various types of measurement in relation to the exposure. That is, the measuring table MTB is provided with a body 159 of the measuring table (measuring table body 159) to which the reflecting mirror 55C, the mover of the linear motor 169, etc. are fixed, and a plate 101 which is fixed to the upper surface of the measuring table body 159 and which is formed of a light-transmissive material having a low coefficient of expansion including silica glass, etc. A chromium film is formed on the substantially entire surface of the plate 101; and the plate 101 has, at a several positions of the plate 101, an area for the measuring device and a reference mark area FM having a plurality of reference marks formed therein as disclosed, for example, in Japanese Patent Application Laid-open No. 5-21314 (corresponding to United States Patent No. 5,243,195), etc.

As shown in Fig. 5, a pair of reference marks FM1, FM2 for an alignment sensor 90 for the mask shown in Fig. 1 and a reference mark FM3 for an alignment sensor ALG for the substrate arranged on a side surface of the projection optical system PL are formed in the reference mark area FM on the plate 101. By measuring the positions of the reference marks by the corresponding alignment sensors respectively, it is possible to measure the baseline amount as the spacing distance (positional relationship) between the projection position of the projection area AR1 of the projection optical system PL and the detecting position of the alignment sensor ALG. When the baseline amount is measured, the liquid immersion area AR2 is formed also on the plate 101. The alignment sensor 90 is used to detect the positional relationship between the mark of the mask M and the reference marks FM1, FM2. The alignment sensor ALG is used to detect the position information about the alignment mark on the substrate P and the reference mark FM3. The alignment sensors 90, ALG of this embodiment perform the mark detection in accordance with the image processing system respectively. However, it is also allowable to adopt any other system including, for example, a system in which a diffracted light beam generated from the mark by being irradiated with the coherent beam is detected.

Various types of measuring aperture patterns are formed in the area for the measuring devices on the plate 101. The measuring aperture patterns include an aperture pattern for measuring a spatial image (for example, a slit-shaped aperture pattern); a pinhole aperture pattern for measuring the uneven illuminance; an aperture pattern for measuring the illuminance; an aperture pattern for measuring the wave aberration; etc. Measuring device, which correspond to the aperture patterns respectively and each of which is constructed of a measuring optical system and a photoelectric sensor, are arranged in the measuring table body 159 disposed on the bottom surface side of the aperture patterns.

Examples of the measuring devices include, for example, an uneven illuminance sensor as disclosed, for example, in Japanese Patent Application Laid-open No. 57-117238 (corresponding to United States Patent No. 4,465,368), a spatial image-measuring device for measuring the light intensity of the spatial image (projected image) of the pattern projected by the projection optical system PL as disclosed, for example, in Japanese Patent Application Laid-open No. 2002-14005 (corresponding to United States Patent application publication No. 2002/0041377), an illuminance monitor as disclosed, for example, in Japanese Patent Application Laid-open No. 11-16816 (corresponding to United States Patent application publication No. 2002/0061469), and a wave aberration-measuring device as disclosed, for example, in International Publication No. 99/60361 (corresponding to European Patent No. 1,079,223).

In this embodiment, corresponding to that the liquid immersion exposure is performed in which the substrate P is exposed with the exposure light EL via the projection optical system PL and the liquid 1, the exposure light EL is received via the projection optical system PL and the liquid 1 in the above-described uneven illuminance sensor, illuminance monitor, spatial image-measuring device, wave aberration-measuring device, etc. to be used for the measurement using the exposure light EL. Therefore, a liquid-repellent coat is applied to the surface of the plate 101.

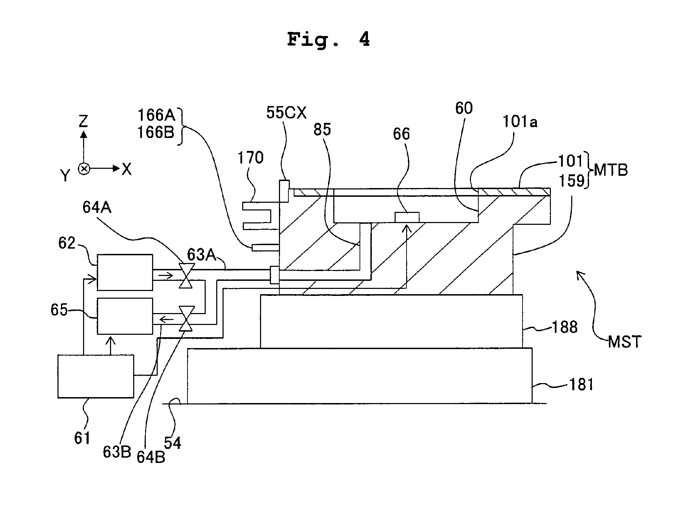

With reference to Fig. 5, a pool portion 60, which is constructed of a substantially rectangular recess and which is provided to temporarily accommodate the cleaning liquid, is formed on the measuring table MTB. The pool portion 60 has a size which is slightly wider than the bottom surface of the nozzle member 30 shown in Fig. 3. As shown in Fig. 4, those connected to the measuring table MTB include another cleaning liquid supply section 62 which is provided to supply, to the pool portion 60, the same or equivalent cleaning liquid as the cleaning liquid supplied from the cleaning liquid supply section 26 shown in Fig. 1, and a cleaning liquid recovery section 65 which is provided to recover the cleaning liquid in the pool portion 60.

With reference to Fig. 4 illustrating the measuring table MTB in cross section, the pool portion 60 is the recess which is formed on the upper surface of the measuring table body 159. An opening 101a is also formed through the plate 101 in conformity with the size of the pool portion 60. A cleaning liquid flow passage 85 is formed to extend from the bottom surface of the pool portion 60 to the side surface of the measuring table body 159. The flow passage 85 is connected to the cleaning liquid supply section 62 via a flexible piping 63A. The cleaning liquid recovery section 65 is connected to the piping 63A via a flexible piping 63B. As an example, the cleaning liquid supply section 62 is provided with a tank for accommodating the cleaning liquid, a pressurizing pump, etc. The cleaning liquid recovery section 65 is provided with a vacuum system (sucking device) such as a vacuum pump, a tank for accommodating the cleaning liquid, etc. Opening/closing valves 64A, 64B are installed at intermediate positions of the pipings 63A, 63B respectively. A controller 61 controls the opening/closing operations of the valves 64A, 64B and the operations of the cleaning liquid supply section 62 and the cleaning liquid recovery section 65. The controller 61 performs the supply and the recovery of the cleaning liquid with respect to the pool portion 60 based on control information from the controller CONT shown in Fig. 1. Specifically, upon supplying the cleaning liquid to the pool portion 60, the valve 64B is closed and the valve 64A is opened. Upon recovering the cleaning liquid from the pool portion 60, the valve 64B is opened and the valve 64A is closed.

An ultrasonic vibrator 66, which is formed of, for example, a piezoelectric ceramics (those based on the barium titanate system or the lead titanate zirconate system (so-called PZT), etc.) or a ferrite vibrator (electrostrictive vibrator), is installed at a central portion of the bottom surface of the pool portion 60. The oscillating operation of the ultrasonic vibrator 66 is also controlled by the controller 61. Upon supplying the cleaning liquid to the pool portion 60 so as to clean or wash the nozzle member 30 shown in Fig. 1, if necessary, an ultrasonic wave of, for example, about 100 kHz to 1 MHz is further generated from the ultrasonic vibrator 66 into the cleaning liquid. This makes it possible to improve the cleaning effect.

As shown in Fig. 1, in a case that the cleaning liquid supply section 26 is provided for the liquid recovery mechanism 20, it is also possible to omit the cleaning liquid supply section 62 shown in Fig. 4. The tank for accommodating the cleaning liquid included in the cleaning liquid supply section 62 may be a detachable vessel or container of the cassette system, and the cleaning liquid recovered by the cleaning liquid recovery section 65 may be returned to the vessel of the cassette system. Further, at least a part of the cleaning liquid supply section 62 and a part of the cleaning liquid recovery section 65 may be each substituted, for example, with an equipment of the factory or the like in which the exposure apparatus EX is installed. The member, which vibrates the cleaning liquid in the pool portion 60, is not limited to the ultrasonic vibrator. For example, it is also allowable to use a stirrer as described later on.

### Exposure Step

With reference to Fig. 1, a plurality of shot areas are defined on the substrate P. The controller CONT of this embodiment moves the substrate stage PST while monitoring the output of the laser interferometer 56B so that the substrate P is advanced along with a predetermined route with respect to the optical axis AX (projection area AR1) of the projection optical system PL to successively expose the plurality of shot areas in the step-and-scan manner. That is, a part of the pattern image (partial pattern image) of the mask M is projected onto the rectangular projection area AR1 by the projection optical system PL during the scanning exposure effected by the exposure apparatus EX. The mask M is moved at a velocity V in the X direction with respect to the projection optical system PL, in synchronization with which the substrate P is moved at a velocity β•V (β represents the projection magnification) in the X direction via the substrate stage PST. After the completion of the exposure of one shot area on the substrate P, another shot area which is to be exposed next is moved to the scanning start position in accordance with the step-movement of the substrate P. The scanning exposure process is successively performed for the respective shot areas thereafter while moving the substrate P in the step-and-scan manner as shown in Fig. 5.

The controller CONT drives the liquid supply mechanism 10 during the exposure process for the substrate P to perform the liquid supply operation for supplying the liquid onto the substrate P. The liquid 1, which is fed from the liquid supply section 11 of the liquid supply mechanism 10, is allowed to flow through the supply tube 12, and then the liquid 1 is supplied onto the substrate P via the supply flow passages 82A, 82B formed in the nozzle member 30. The liquid 1 supplied onto the substrate P flows under or below the projection optical system PL in conformity with the movement of the substrate P. For example, when the substrate P is moved in the +X direction during the exposure of a certain shot area, the liquid 1 flows under or below the projection optical system PL at approximately a velocity same as that of the substrate P in the +X direction which is the same as the direction of the substrate P. In this state, the exposure light EL, radiated from the illumination optical system IL and passed through the mask M, is irradiated onto the image plane side of the projection optical system PL, thereby exposing the substrate P with the pattern of the mask M via the projection optical system PL and the liquid 1 of the liquid immersion area AR2. The controller CONT performs the supply of the liquid 1 onto the substrate P by the liquid supply mechanism 10 when the exposure light EL is irradiated onto the image plane side of the projection optical system PL, i.e., during the exposure operation for the substrate P. The liquid immersion area AR2 is formed satisfactorily by continuing the supply of the liquid 1 by the liquid supply mechanism 10 during the exposure operation. On the other hand, the controller CONT performs the recovery of the liquid 1 on the substrate P by the liquid recovery mechanism 20 when the exposure light EL is radiated onto the image plane side of the projection optical system PL, i.e., during the exposure operation for the substrate P. It is possible to suppress the expansion of the liquid immersion area AR2 by continuously executing the recovery of the liquid 1 by the liquid recovery mechanism 20 during the exposure operation (when the exposure light EL is irradiated onto the image plane side of the projection optical system PL).

In this embodiment, the liquid supply mechanism 10 supplies the liquid 1 onto the substrate P simultaneously from the both sides of the projection area AR1 through the supply ports 13, 14 of the nozzle member 30 during the exposure operation. Accordingly, the liquid 1, supplied from the supply ports 13, 14 onto the substrate P, is satisfactorily spread in the space between the substrate P and the lower end surface of the optical element 2 disposed at the terminal end of the projection optical system PL and the space between the substrate P and the lower surface of the nozzle member 30 (first member 31). The liquid immersion area AR2 is formed in a range which is wider than at least the projection area AR1. If the supply ports 13, 14 are connected to another liquid supply sections, a liquid supply amount per unit time, which is to be supplied from a position approaching the projection area AR1 in relation to the scanning direction, may be set to be greater than a liquid supply amount which is to be supplied from a position on a side opposite to the position approaching the projection area AR1.

It is also allowable that the recovery operation for recovering the liquid 1 by the liquid recovery mechanism 20 is not performed during the exposure operation, and the flow passage of the recovery tube 22 is opened after the completion of the exposure to recover the liquid 1 on the substrate P. As an example, the liquid 1 on the substrate P may be recovered by the liquid recovery mechanism 20 only during a partial period (at least a part of the stepping movement period of the substrate P) after the completion of the exposure for a certain shot area on the substrate P and until the start of the exposure for a shot area to be exposed next to the certain shot area .

The controller CONT continues the supply of the liquid 1 by the liquid supply mechanism 10 during the exposure of the substrate P. By continuously supplying the liquid 1 as described above, it is possible not only to fill the space between the projection optical system PL and the substrate P with the liquid 1 satisfactorily, but also to avoid the generation of the vibration of the liquid 1 (so-called the water hammer phenomenon) as well. In this way, all of the shot areas on the substrate P can be subjected to the exposure by the liquid immersion method.

The controller CONT moves the measuring stage MST to the position opposite to the optical element 2 of the projection optical system PL, for example, during the exchange of the substrate P, and forms the liquid immersion area AR2 on the measuring stage MST. In this case, by moving the substrate stage PST and the measuring stage MST in a state that the substrate stage PST and the measuring stage MST are allowed to approach closely to each other, and by arranging one of the stages to be opposite to the optical element 2 when the one stage is exchanged with the other of the stages, the liquid immersion area AR2 is moved between the substrate stage PST and the measuring stage MST. The controller CONT executes the measurement in relation to the exposure (for example, the baseline measurement) by using at least one measuring device (measuring member) provided on the measuring stage MST in a state that the liquid immersion area AR2 is formed on the measuring stage MST. With this, it is possible to obtain the information (for example, the baseline amount and the illuminance of the exposure light EL) necessary for the liquid immersion exposure for the substrate P. Details of the operation for moving the liquid immersion area AR2 between the substrate stage PST and the measuring stage MST and the measuring operation of the measuring stage MST during the exchange of the substrate P are disclosed, for example, in International Publication No. 2005/074014 (corresponding to European Patent Application Publication No. 1713113) and International Publication No. 2006/013806. The exposure apparatus, which is provided with the substrate stage and the measuring stage, is disclosed, for example, in Japanese Patent Application Laid-open No. 11-135400 (corresponding to International Publication No. 1999/23692) and Japanese Patent Application Laid-open No. 2000-164504 (corresponding to United States Patent No. 6,897,963). The contents of United States Patent No. 6,897,963 is incorporated herein by reference within a range of permission of the domestic laws and ordinances of the designated state and the selected state.

### Cleaning Step

When the substrate P shown in Fig. 1 comes into contact with the liquid 1 of the liquid immersion area AR2 in the exposure step as described above, a part of components of the substrate P is eluted into the liquid 1 in some cases. For example, in a case that a chemical amplification type resist is used as the photosensitive material on the substrate P, the chemical amplification type resist includes a base resin, a photo acid generator (PAG) contained in the base resin, and an amine-based substance called "quencher". When the resist as described above comes into contact with the liquid 1, the part of the components of the resist, specifically PAG, the amine-based compound, etc. are eluted into the liquid 1 in some cases. Even in a case that the base material of the substrate P itself (for example, the silicon substrate) comes into contact with the liquid 1, there is such a possibility that a part of components of the base material (silicon, etc.) might be eluted into the liquid 1 depending on the substances constructing the base material.

As described above, there is such a possibility that the liquid 1, which comes into contact with the substrate P, might contain a minute foreign matter such as particles composed of the resist residue, the impurities generated from the substrate P, etc. There is also such a possibility that the liquid 1 might contain a minute foreign matter such as the impurities and the dust in the atmospheric air. Therefore, there is such a possibility that the liquid 1, which is recovered by the liquid recovery mechanism 20, might contain the foreign matter including various impurities, etc. In view of the above, the liquid recovery mechanism 20 discharges the recovered liquid 1 to the outside. At least a part of the recovered liquid 1 may be cleaned by an internal processing apparatus, and then the cleaned liquid 1 may be returned to the liquid supply mechanism 10.

It is feared that the foreign matter such as the particles, etc., which has the size larger than the meshes of the mesh filter 25 provided on the recovery port 24 of the nozzle member 30 shown in Fig. 1 and which enters into and mixes with the liquid 1 of the liquid immersion area AR2, might adhere to and remain on a surface (outer surface) of the mesh filter 25, etc. Further, other than the mesh filter 25, the foreign matter adheres to the liquid contact area of the nozzle member 30, etc. in some cases. It is feared that the foreign matter remaining as described above might enter into and mix with the liquid 1 of the liquid immersion area AR2 again during the exposure of the substrate P. If the foreign matter, which entered into and mixed with the liquid 1, adheres onto the substrate P, it is feared that any deficiency including the shape defect, etc. might arise in the pattern to be formed on the substrate P.

In view of the above, the exposure apparatus EX of this embodiment executes the cleaning of the foreign matter, remaining on the nozzle member 30, during the maintenance performed periodically or requested by an operator, etc. for the liquid supply mechanism 10 and the liquid recovery mechanism 20, for example, as follows. The particle level of the liquid recovered by the liquid recovery section 21 may be always monitored, and the following maintenance including the cleaning step may be executed when the particle level exceeds a predetermined allowable range. For example, a particle counter may be provided to measure the number of foreign matters (particles) via a branch tube at an intermediate portion of the recovery tube 22, and the number of particles in the recovered liquid may be monitored. As an example, the particle counter extracts the liquid in a predetermined volume at a predetermined sampling rate from the recovered liquid, irradiates the laser beam onto the extracted liquid, and performs image processing for an image of the scattered light to thereby measure the number of particles in the liquid.

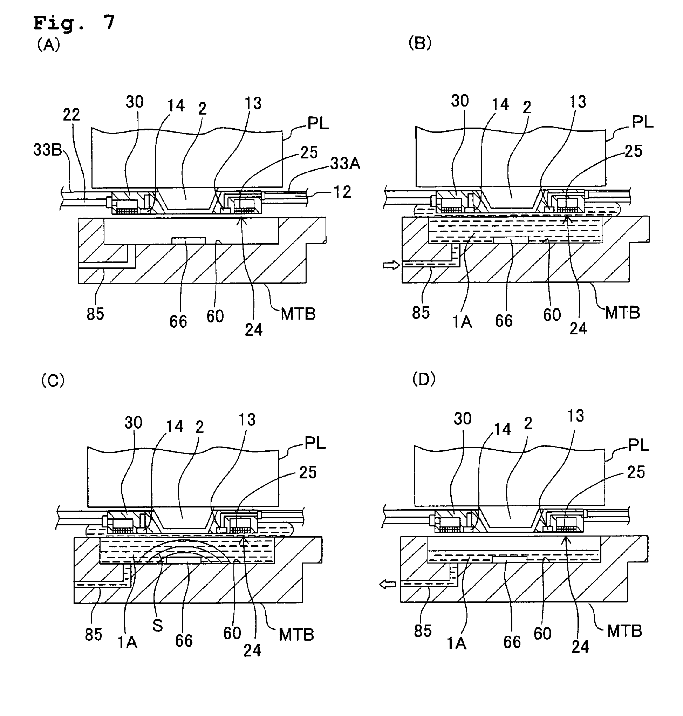

In the cleaning step, the measuring table MTB of the measuring stage MST is brought into tight contact with (or make approach closely to) the substrate holder PH disposed on the substrate stage PST as shown in Fig. 6 in a state that the radiation of the exposure light EL is stopped. Subsequently, the substrate stage PST and the measuring table MTB (measuring stage MST) are simultaneously moved in the +X direction to move the pool portion 60 on the measuring table MTB to the position just under or below the projection optical system PL. After that, the substrate stage PST may be further retracted in the +X direction. As a result, as shown in Fig. 7(A), the pool portion 60 disposed on the measuring table MTB is moved to the bottom surface (moved to a position corresponding to the bottom surface or to a position opposite to or facing the bottom surface) of the nozzle member 30 which is supported by the unillustrated column mechanism via support members 33A, 33B (coated with the liquid-repellent coat) so as to surround the optical element 2 disposed at the end portion of the projection optical system PL. The operation performed therebefore can be regarded as the moving step, and the operation to be performed thereafter can be regarded as the cleaning step as well.

In this state, the valve 64B shown in Fig. 4 is closed and the valve 64A is opened to supply the cleaning liquid from the cleaning liquid supply section 62 to the pool portion 60. As shown in Fig. 7(B), the cleaning liquid 1A is allowed to overflow from the pool portion 60 so that the cleaning liquid 1A is permeated into the interior of the nozzle member 30 via the mesh filter 25 of the recovery port 24 of the nozzle member 30. In this process, the cleaning liquid 1A is also permeated into the interior of the supply ports 13, 14. In this state, although the supply of the cleaning liquid 1A is stopped, the cleaning liquid 1A is retained between the nozzle member 30 and the measuring table MTB owing to the action of the surface tension of the cleaning liquid 1A, the liquid-repellent coats of the support members 33A, 33B, and the liquid-repellent coat of the upper surface of the measuring table MTB. In this situation, most of the foreign matters, which adhere to the interior of the supply ports 13, 14 and the mesh filter 25 disposed in the nozzle member 30, enters into and mixes with the cleaning liquid 1A, and the foreign matters are sedimented or precipitated on the bottom surface of the pool portion 60.

After that, if necessary, as shown in Fig. 7(C), ultrasonic wave S is generated from the ultrasonic vibrator 66 toward the nozzle member 30 via the cleaning liquid 1A. By doing so, in particular, the mesh filter 25 of the nozzle member 30 is ultrasonically cleaned. Any foreign matter, which tightly adheres to the interior of the mesh filter 25, is mixed or eluted into the cleaning liquid 1A from the filter 25. In a case that the cleaning effect is sufficiently high with only the cleaning liquid 1A, the ultrasonic cleaning step may be omitted. The relative movement (vibration) of the nozzle member 30 and the measuring table MTB may be used in combination of the ultrasonic cleaning, or the relative movement (vibration) may be used substitutively therewith.

Subsequently, with reference to Fig. 4, the valve 64A is closed and the valve 64B is opened to recover the cleaning liquid 1A in the pool portion 60 by the cleaning liquid recovery section 65. As a result, as shown in Fig. 7(D), any foreign matter, which remains on the mesh filter 25 of the nozzle member 30, etc., is recovered together with the cleaning liquid 1A to the cleaning liquid recovery section 65 shown in Fig. 4. If necessary, it is also appropriate to repeat the cleaning step ranging from Fig. 7(A) to Fig. 7(D) a plurality of times.

The function and the advantage of the cleaning step of this embodiment are summarized as follows.
A1: As shown in Fig. 7(B), the cleaning liquid 1A is supplied into the nozzle member 30 via the recovery port 24 and the supply ports 13, 14. Therefore, at least a part of the foreign matter, which is accumulated in the nozzle member 30 when the exposure is performed in accordance with the liquid immersion method, can be removed together with the cleaning liquid 1A. In this procedure, the cleaning liquid 1A is supplied by using the measuring stage MST. Therefore, no influence is exerted on the substrate stage PST on which the substrate P is held. Further, it is possible to efficiently perform the maintenance for the liquid supply mechanism 10 and the liquid recovery mechanism 20 (as well as the maintenance for the exposure apparatus), for example, during the measurement of the baseline amount. As a result, the amount of the foreign matter is decreased in the liquid of the liquid immersion area AR2 on the substrate P in the exposure step to be performed thereafter. Therefore, for example, the shape error of the pattern to be transferred is reduced, and it is possible to perform the exposure highly accurately.

For example, with reference to Fig. 1, in a case that the liquid supply ports 13, 14 and the recovery port 24 are provided on distinct or different nozzle members, it is also allowable that any one of the nozzle members is merely cleaned in the cleaning step. Also in this case, the amount of the foreign matter in the liquid is decreased during the exposure to be performed thereafter. A2: As shown in Fig. 7(B), the cleaning liquid 1A is supplied to the upper surface from the pool portion 60 on the upper surface of the measuring table MTB disposed at the upper portion of the measuring stage MST so that the cleaning liquid 1A is allowed to overflow. Therefore, the cleaning liquid 1A can be supplied to the nozzle member 30 by using the simple construction, without changing the position of the measuring table MTB in the Z direction.

In the case of the system in which the cleaning liquid 1A is allowed to overflow from the pool portion 60 as described above, it is not necessarily indispensable that the pool portion (recess) 60 is formed on the measuring table MTB; and it is also allowable that the upper surface of the measuring table MTB is the flat surface as it is. In this case, the ultrasonic vibrator, etc. which vibrates the cleaning liquid 1A may be provided on the nozzle member 30, not on the measuring table MTB. With reference to Fig. 1, the measuring stage MST of this embodiment is provided with the leveling table 188. Accordingly, the driving amount of the leveling table 188 in the Z direction may be increased; and the measuring table MTB may be moved upwardly in the upward direction (+Z direction) in a state that the pool portion 60 is filled with the cleaning liquid 1A with reference to Fig. 7(B), and the bottom surface portion of the nozzle member 30 may be immersed in the cleaning liquid 1A in the pool portion 60. Also in this way, it is possible to supply the cleaning liquid 1A into the nozzle member 30 via the supply ports 13, 14 and the recovery port 24 (mesh filter 25). After that, the ultrasonic cleaning is performed, if necessary, and then the measuring table MTB is moved downwardly. By doing so, any foreign matter in the nozzle member 30 is removed, and the foreign matter is precipitated in the pool portion 60. In a case that the exposure apparatus EX is provided with an attaching/detaching mechanism (or an exchange mechanism) for the nozzle member 30, then the nozzle member 30 may be moved downwardly in the downward direction (-Z direction) by this mechanism, and the nozzle member 30 may be immersed in the cleaning liquid 1A.

A3: The nozzle member 30 is arranged to surround the optical element 2 closest to the image plane of the projection optical system PL. Further, the mesh filter 25 is provided on the recovery port 24 of the nozzle member 30. In the cleaning step described above, the entire surface of the mesh filter 25 is immersed in the cleaning liquid 1A. Therefore, it is possible to efficiently remove the foreign matter adhered to the mesh filter 25. A4: The cleaning step described above includes the step of ultrasonically vibrating the cleaning liquid 1A.
Therefore, it is possible to enhance the cleaning effect of the nozzle member 30. However, it is not necessarily indispensable to perform the ultrasonic cleaning.

A5: The cleaning step described above includes, in the end of the cleaning step, the step of recovering the cleaning liquid 1A. Therefore, the cleaning liquid 1A, into which the foreign matter entered and mixed therewith, can be discharged to the outside.
The cleaning liquid 1A can be also recovered by the liquid recovery section 21, for the liquid, of the liquid immersion exposure shown in Fig. 1. Accordingly, it is possible to simplify the liquid recovery mechanism (as well as the cleaning mechanism) as a whole. A6: In the embodiment described above, the liquid 1 for the liquid immersion exposure is of the type different from that of the cleaning liquid 1A. Therefore, it is possible to use, as the cleaning liquid 1A, a liquid having a high cleaning effect including a solvent, etc.

It is also possible to use the liquid 1 itself as the cleaning liquid 1A. In this case, the liquid supply section 11 shown in Fig. 1 can be used for both of the cleaning liquid supply section 26 shown in Fig. 1 and the cleaning liquid supply section 62 shown in Fig. 4, thereby making it possible to simplify the construction of the liquid supply mechanism (i.e., the cleaning mechanism). Further, in the embodiment described above, the measuring stage MST is connected to the cleaning liquid supply section 62 and the cleaning liquid recovery section 65 via the flexible pipings 63A, 63B. However, it is also allowable to release the connection between the measuring stage MST and the cleaning liquid supply section 62 and cleaning liquid recovery section 65 by the pipings 63A, 63B, for example, when any operation (the measuring operation, etc.) other than the cleaning operation is performed. With this, the measuring stage MST can be moved (positionally controlled) highly accurately during the measuring operation, etc. In the embodiment described above, the measuring stage MST is provided with at least a part of the cleaning mechanism. However, there is no limitation to this. A movable member (for example, a movable stage such as a stage to be exclusively used for the cleaning), which is different from the measuring stage MST, may be provided, and the cleaning may be performed on the movable member in the same manner as described above.

### Second Embodiment

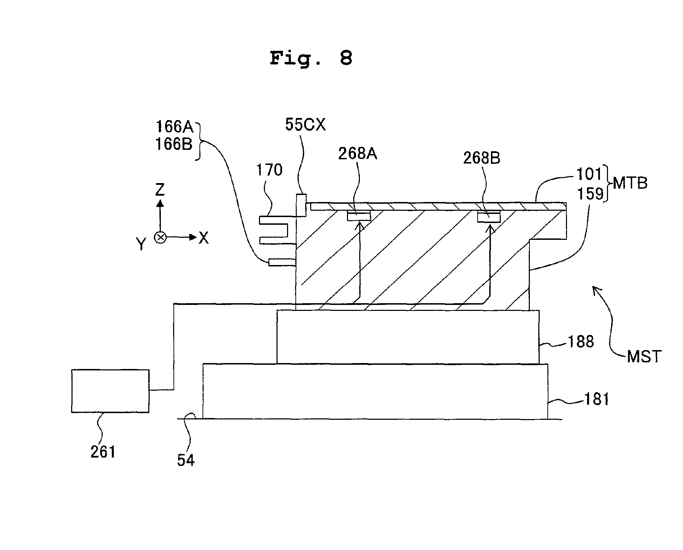

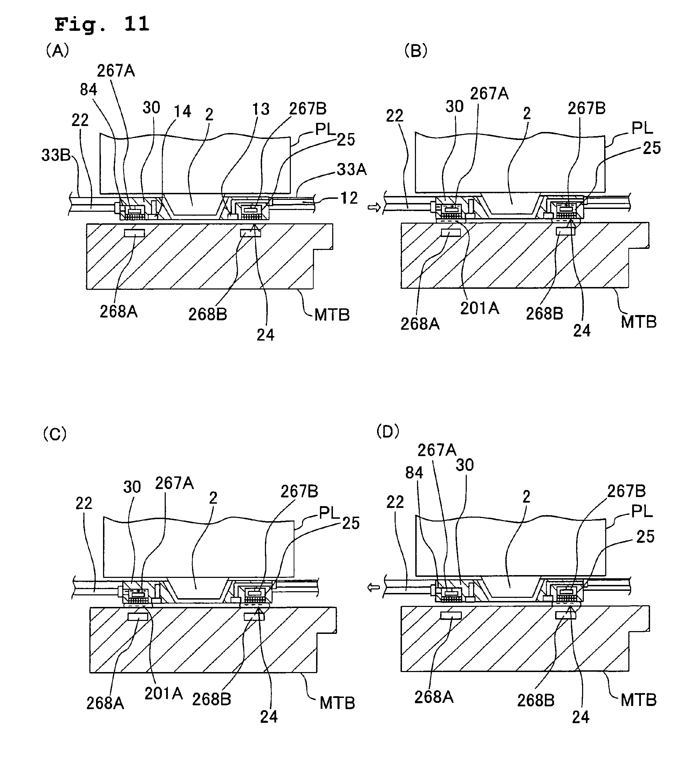

Next, the second embodiment of the present invention will be explained with reference to Figs. 8 to 11. In Figs. 8 to 11, the constitutive components or parts, which are the same as the constitutive components or parts described in the first embodiment, are designated by the same reference numerals, any explanation of which will be omitted. In this embodiment, the internal structures of the measuring table MTB and the nozzle member 30 and the cleaning step are different from those of the first embodiment. However, the exposure step of this embodiment is the same as or equivalent to that of the first embodiment. An explanation will be made with reference to Figs. 8 and 11 about the internal structures of the measuring table MTB and the nozzle member 30.

### Stirrer for Cleaning Liquid

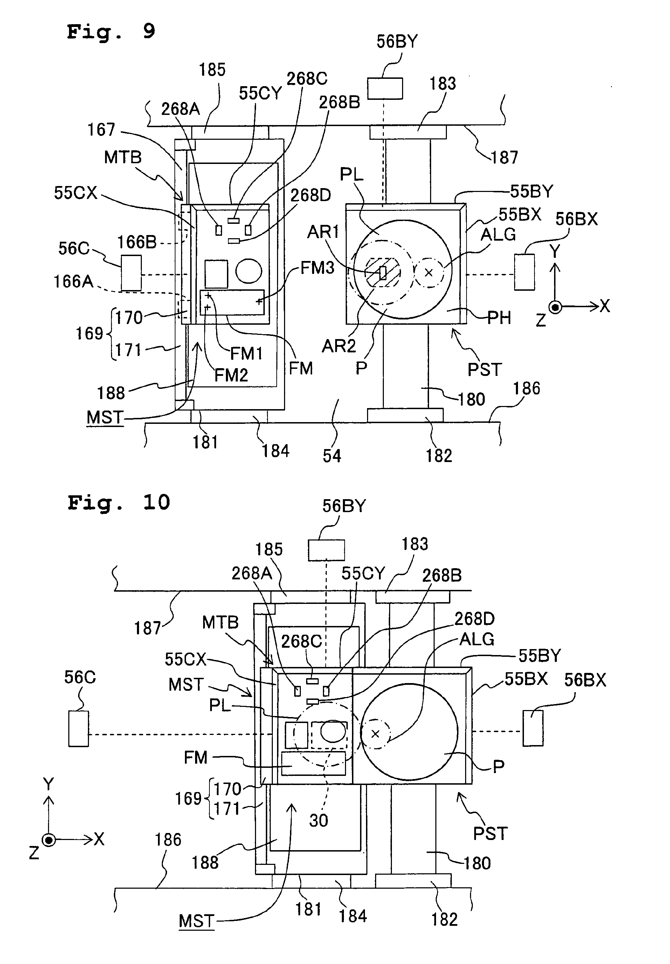

As shown in Fig. 11(A), a plurality of stirring bars 267A, 267B supported rotatably (or vibratably), etc. are arranged in a space (predetermined space) over or above the mesh filter 25 in the recovery port 24 of the nozzle member 30 of this embodiment. The stirring bars 267A, 267B, etc. are actually arranged at four positions at equal intervals. However, the stirring bars are representatively referred to as the stirring bars 267A, 267B in the following description. The stirring bars 267A, 267B of this embodiment are magnetic stirrer bars each of which is constructed of a rod-shaped permanent magnet.
Corresponding to this, a plurality of driving sections 268A, 268B, 268C, 268D, each of which includes a plurality of electromagnetic coils to rotate or vibrate the stirring bars 267A, 267B simultaneously in a non-contact manner, are embedded in an upper portion of the measuring table MTB of the measuring stage MST (see Fig. 9). The plurality of stirring bars 267A, 267B may be successively driven by the driving section 268A disposed at one position.

The cleaning liquid is stirred or agitated (vibrated) by the stirring bars 267A, 267B in order to enhance the cleaning effect when the cleaning liquid is injected into the nozzle member 30 to clean the mesh filter 25 as described later on. In principle, it is enough that the cleaning liquid is vibrated. Therefore, ultrasonic vibrators may be used instead of the stirring bars 267A, 267B. A rotatable small fan may be used as each of the stirring bars 267A, 267B, etc. The fan may be rotated by a small motor provided in the nozzle member 30.

With reference to Fig. 8 illustrating the measuring table MTB in cross section, the driving sections 268A, 268B, etc. are fixed in the measuring table body 159 covered with the plate 101. The operation for driving the stirring bars 267A, 267B in the nozzle member 30 shown in Fig. 11(A), which is effected by the driving sections 268A, 268B, is controlled by a controller 261. The controller 261 rotates or vibrates the stirring bars 267A, 267B based on control information from the controller CONT shown in Fig. 1.

In a case that the ultrasonic vibrator is used instead of the stirring bars 267A, 267B shown in Fig. 11(A), those usable as the ultrasonic vibrator include, for example, a piezoelectric ceramics (those based on, for example, the barium titanate system or the lead titanate zirconate system (so-called PZT)) or a ferrite vibrator (electrostrictive vibrator), etc. In a case that the cleaning liquid is supplied into the nozzle member 30 from the cleaning liquid supply section 26 shown in Fig. 1 to clean the nozzle member 30, then the stirring bars 267A, 267B are, for example, rotated, or the ultrasonic wave of, for example, about 100 kHz to 1 MHz is generated from the ultrasonic vibrator into the cleaning liquid. Accordingly, it is possible to improve the cleaning effect.

A cleaning liquid supply section, which supplies the cleaning liquid toward the nozzle member 30, may be provided in the measuring table MTB. Further, the tank for accommodating the cleaning liquid included in the cleaning liquid supply section 26 may be a detachable vessel or container of the cassette system; the liquid recovered by the liquid recovery section 21 may be returned to the vessel of the cassette system; and the liquid may be used as the cleaning liquid.

Next, the cleaning step in this embodiment will be explained with reference to Figs. 10 and 11. The exposure step is executed in the same manner as in the first embodiment. After that, in a state that the irradiation of the exposure light EL is stopped, as shown in Fig. 10, the measuring table MTB of the measuring stage MST is brought into tight contact with (or make approach to) the substrate holder PH disposed on the substrate stage PST. Subsequently, the substrate stage PST and the measuring table MTB (measuring stage MST) are simultaneously moved in the +X direction to move the driving sections 268A to 268D of the measuring table MTB to the bottom surface of the projection optical system PL. After that, the substrate stage PST may be further retracted in the +X direction. As a result, as shown in Fig. 11(A), the driving sections 268A, 268B on the measuring table MTB are moved to the bottom surface portions of the stirring bars 267A, 267B of the nozzle member 30 supported by the unillustrated column mechanism via the support members 33A, 33B (coated with the liquid-repellent coat) so that the optical element 2 disposed at the end portion of the projection optical system PL is surrounded therewith.

In this state, the valve 23 shown in Fig. 1 is closed and the valve 28 shown in Fig. 1 is opened to supply a cleaning liquid 201A from the cleaning liquid supply section 26 to the recovery port 24 of the nozzle member 30 via the supply tube 27, the recovery tube 22, and the recovery flow passage 84. As shown in Fig. 11(B), a space (space in which the stirring bars 267A, 267B are installed), which is located over or above the mesh filter 25 installed at the recovery port 24 in the nozzle member 30, is filled with the cleaning liquid 201A. In this procedure, the cleaning liquid 201A is allowed to gradually inflow also onto the measuring table MTB via the recovery port 24. However, since the upper surface of the measuring table MTB is liquid-repellent, the cleaning liquid 201A is scarcely diffused or scattered.

Subsequently, as shown in Fig. 11(C), in order to enhance the cleaning effect of the mesh filter 25, the stirring bars 267A, 267B in the nozzle member 30 are driven and rotated, thereby vibrating the cleaning liquid 201A disposed over or above the mesh filter 25 in the nozzle member 30 by the stirring. Accordingly, most of the foreign matters adhering to the mesh filter 25 in the nozzle member 30 is made to enter into and mix with the cleaning liquid 201A or is dissolved in the cleaning liquid 201A.

Subsequently, the valve 28 shown in Fig. 1 is closed and the valve 23 shown in Fig. 1 is opened. As shown in Fig. 11(D), the cleaning liquid 1A in the nozzle member 30 and on the measuring table MTB is recovered by the liquid recovery section 21 shown in Fig. 1 via the recovery flow passage 84. As a result, the foreign matter remaining on the mesh filter 25 of the nozzle member 30, etc. is recovered together with the cleaning liquid 201A by the liquid recovery section 21 shown in Fig. 1. If necessary, it is also appropriate to repeat the cleaning step ranging from Fig. 11(A) to Fig. 11(D) a plurality of times.

The function and the advantage of the cleaning step of this embodiment are summarized as follows.
B1: As shown in Fig. 11(B), the cleaning liquid 201A is supplied to the space in the recovery port 24 of the nozzle member 30. Therefore, at least a part of the foreign matter, which is accumulated in the nozzle member 30 when the exposure is performed in accordance with the liquid immersion method, can be removed together with the cleaning liquid 201A. In this procedure, the cleaning liquid 201A is vibrated by the stirring bars 267A, 267B (or the ultrasonic vibrator, etc.) in the nozzle member 30. Therefore, it is possible to quickly clean the inside of the nozzle member 30. This makes it possible to efficiently perform the maintenance for the liquid supply mechanism 10 and the liquid recovery mechanism 20 (as well as the maintenance for the exposure apparatus). As a result, the amount of the foreign matter in the liquid of the liquid immersion area AR2 on the substrate P is decreased in the exposure step to be performed thereafter. Therefore, the shape error, etc. of the pattern to be transferred is reduced, thereby making it possible to perform the exposure highly accurately.

For example, with reference to Fig. 1, in a case that the liquid supply ports 13, 14 and the recovery port 24 are provided on distinct or different nozzle members, it is also allowable to clean only any one of the nozzle members in the cleaning step. With this also, the amount of the foreign matter in the liquid is also decreased during the exposure to be performed thereafter. B2: In a case that the cleaning liquid 201A is supplied from the cleaning liquid supply section 26 shown in Fig. 1 into the nozzle member 30, the cleaning liquid 201A is supplied into the nozzle member 30 along with the recovery flow passage 84 and a part of the recovery tube 22 through which the liquid 1, supplied to the liquid immersion area AR2 during the exposure based on the liquid immersion method, is recovered. Therefore, it is possible to simplify the supply mechanism for the cleaning liquid 201A (as well as the cleaning mechanism).

B3: The cleaning liquid may be supplied onto the measuring table MTB from a cleaning liquid supply section (not shown) in the measuring table MTB, instead of supplying the cleaning liquid 201A into the nozzle member 30 from the cleaning liquid supply section 26 shown in Fig. 1 via the recovery flow passage 84; and the cleaning liquid may be permeated into the recovery port 24 and the supply ports 13, 14 of the nozzle member 30. In this procedure, it is possible to easily clean the interior of the supply ports 13, 14 of the nozzle member 30 as well.

B4: The nozzle member 30 of this embodiment is arranged to surround the optical element 2 closest to the image plane of the projection optical system PL, and the mesh filter 25 is provided on the recovery port 24 of the nozzle member 30. In the cleaning step described above, the cleaning liquid 201A is vibrated by the stirring bars 267A, 267B in the vicinity of the mesh filter 25. Therefore, it is possible to efficiently remove the foreign matter adhered to the mesh filter 25.

B5: The cleaning step described above includes, in the end of the cleaning step, the step of recovering the cleaning liquid 201A. Therefore, the cleaning liquid 201A, into and with which the foreign matter entered and mixed, can be discharged to the outside. B6: In the embodiment described above, the liquid 1 for the liquid immersion exposure is of the type different from that of the cleaning liquid 201A. Therefore, it is possible to use, as the cleaning liquid 201A, a liquid having a high cleaning effect including the solvent, etc. It is also possible to use the liquid 1 itself as the cleaning liquid 201A. In this case, the liquid supply section 11 shown in Fig. 1 can be also used as the cleaning liquid supply section 26 shown in Fig. 1. It is possible to simplify the construction of the supply mechanism for the liquid and the cleaning liquid (as well as the cleaning mechanism).

### Third Embodiment

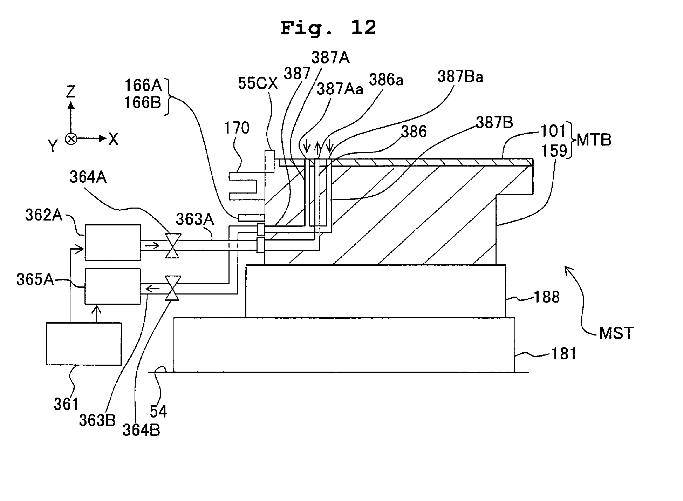

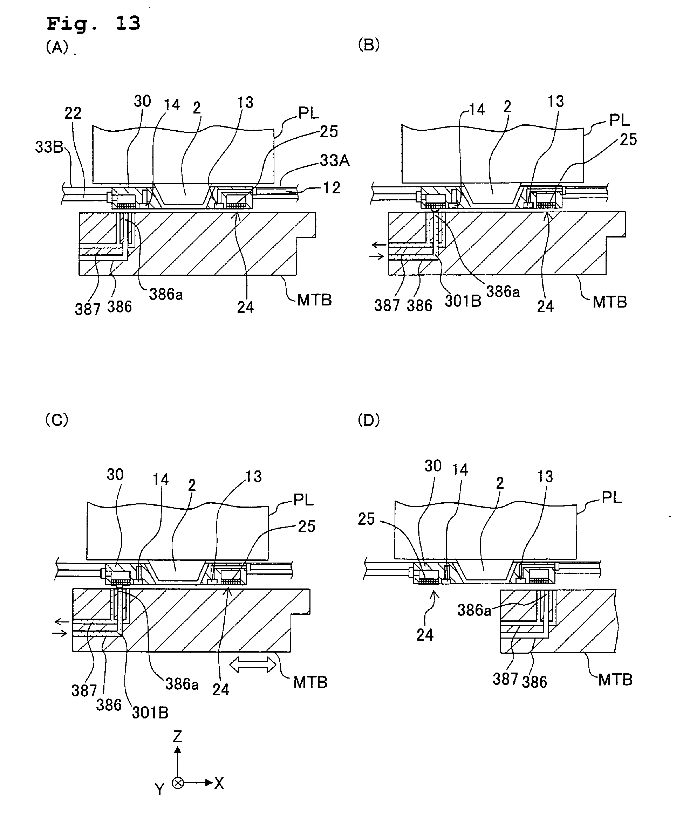

Next, the third embodiment of the present invention will be explained with reference to Figs. 12 and 13. An exposure apparatus of this embodiment is basically constructed in the same manner as the exposure apparatus EX shown in Fig. 1. However, in the case of the exposure apparatus of this embodiment, the cleaning mechanism for cleaning the nozzle member 30 differs from that of the exposure apparatus as shown in Fig. 1. In Figs. 12 and 13, the constitutive components or parts, which are the same as the constitutive components or parts of the first embodiment, are designated by the same reference numerals, any explanation of which will be omitted. Fig. 12 shows a sectional view of a measuring table MTB disposed on the measuring stage MST of this embodiment. With reference to Fig. 12, a jetting port 386a, which is provided to jet the cleaning liquid, is formed on an upper surface (plate 101) of a measuring table body 159. A plurality of gas sucking ports (representatively shown by two sucking ports 387Aa, 387Ba) are formed to surround the jetting port 386a. As for a form to jet the cleaning liquid in this embodiment, the cleaning liquid is sprayed in a form of mist. As another form to jet the cleaning liquid, it is also allowable that the cleaning liquid is jetted at a high pressure to perform the high pressure cleaning. It is also possible to use these forms alternately or substitutively depending on the degree or extent of the dirt or pollution.

The jetting port 386a is connected to a cleaning liquid jetting device 362A via a supply flow passage 386 disposed in the measuring table body 159 and via a flexible piping 363A disposed outside the measuring table body 159. The sucking ports 387Aa, 387Ba are communicated with a suction flow passage 387 via branch flow passages 387A, 387B in the measuring table body 159. The suction flow passage 387 is connected to a sucking device 365A for the gas or mist-like liquid via a flexible piping 363B disposed at the outside. Opening/closing valves 364A, 364B are installed to the pipings 363A, 363B respectively. As described above, the cleaning mechanism of this embodiment is a cleaning liquid jetting mechanism of the differential evacuation type in which the jetting port 386a and the sucking ports 387Aa, 387Ba are arranged closely to one another.

The type of the cleaning liquid jetted from the jetting device 362A is the same as that of the cleaning liquid supplied from the cleaning liquid supply section 26 shown in Fig. 1. The controller CONT shown in Fig. 1 controls the operation of the cleaning mechanism including the measuring table MTB in which the jetting device 362A, the sucking device 365A, the valves 364A, 364B, the jetting port 386a, and the sucking ports 387Aa, 387Ba are formed. In this embodiment, the jetting port 386a and the sucking ports 387Aa, 387Ba have small diameters, and liquid-repellent coats are applied therein. Therefore, even if the liquid immersion area AR2 is positioned on the jetting port 386a and the sucking ports 387Aa, 387Ba when the cleaning is not performed (when the ordinary exposure or the measurement is performed), the liquid does not advance or enter into the jetting port 386a and the sucking ports 387Aa, 387Ba. Since the interiors of the jetting port 386a and the sucking ports 387Aa, 387Ba are liquid-repellent, the interiors thereof are prevented from being contaminated or polluted. Further, various mesh filters can be attached to the end portion of the jetting port 386a. By changing the mesh shape, it is possible to jet the cleaning liquid from the jetting port 386a while the cleaning liquid is shaped into various shapes including radial, straight, conical shapes, etc. For example, it is also allowable to experimentally select one mesh shape having a high cleaning effect among those mesh shapes as described above (forms to jet the cleaning liquid). The cleaning mechanism of this embodiment can be provided also for the substrate holder PH on the substrate stage PST shown in Fig. 1. A part or parts of the cleaning mechanism may be substituted, for example, with an equipment of the factory or the like in which the exposure apparatus EX is installed.

Next, an example will be explained with reference to Fig. 13 about the operation to be performed upon cleaning the nozzle member 30 shown in Fig. 1 by using the cleaning mechanism of this embodiment in a case that the maintenance is performed, for example, for the liquid supply mechanism 10 and the liquid recovery mechanism 20 shown in Fig. 1. At first, as shown in Fig. 13(A), the cleaning liquid jetting port 386a on the measuring table MTB is moved to the bottom surface of the recovery port 24 of the nozzle member 30 supported by the unillustrated column mechanism via the support members 33A, 33B so that the optical element 2 disposed at the end portion of the projection optical system PL is surrounded therewith.

In this state, the valves 364A, 36B shown in Fig. 12 are opened to supply the cleaning liquid from the jetting device 362A in a jetting state to the supply flow passage 386 via the piping 363A, and to suck the gas from the suction flow passage 387 by the sucking device 365A via the piping 363B. As a result, as shown in Fig. 13(B), a cleaning liquid 301B is jetted from the jetting port 386a disposed at the end of the supply flow passage 386 of the measuring table MTB toward the recovery port 24 (or the supply ports 13, 14) of the nozzle member 30; and simultaneously therewith, the jetted cleaning liquid 301B is subjected to the sucking evacuation (differential evacuation) via the suction flow passage 387 from the plurality of sucking ports. In this procedure, the foreign matter, adhering to the mesh filter 25 in the recovery port 24 (or in the supply ports 13, 14), is removed together with the mist-like cleaning liquid 301B, and the foreign matter is discharged from the suction flow passage 387.

Subsequently, in the state that the jetting and the differential evacuation are performed for the cleaning liquid 301B as described above, as shown in Fig. 13(C), the measuring table MTB is moved in the X direction and the Y direction so that the cleaning liquid 301B jetted from the jetting port 386a is jetted to the substantially entire surfaces of the recovery port 24 and the supply ports 13, 14 of the nozzle member 30. Then, as shown in Fig. 13(D), the jetting and the differential evacuation for the cleaning liquid 301B are stopped at a point of time at which the cleaning liquid 301B jetted from the jetting port 386a of the measuring table MTB is allowed to pass across the substantially entire surfaces of the recovery port 24 and the supply ports 13, 14 of the nozzle member 30, thereby bringing the cleaning step to an end. As a result, the foreign matter remaining on the mesh filter 25 of the nozzle member 30, etc. is recovered together with the cleaning liquid 301B by the sucking device 365A shown in Fig. 12. If necessary, it is also appropriate to repeat the cleaning step ranging from Fig. 13(A) to Fig. 13(D) a plurality of times. Further, the cleaning liquid may be supplied to the nozzle member 30 from the cleaning liquid supply section 26 shown in Fig. 1 together with the jetting and the differential evacuation of the cleaning liquid.

The function and the advantage of the cleaning step of this embodiment are summarized as follows. C1: As shown in Fig. 13(B), the cleaning liquid 301B is jetted from the side of the measuring table MTB (measuring stage MST) toward the recovery port 24 and the supply ports 13, 14 of the nozzle member 30 in order to clean the nozzle member 30. Therefore, it is possible to efficiently remove the foreign matter adhering to the interior of the nozzle member 30. Therefore, it is possible to efficiently perform the maintenance for the liquid supply mechanism 10 and the liquid recovery mechanism 20 (as well as the maintenance for the exposure apparatus).

For example, in a case that the liquid supply ports 13, 14 and the recovery port 24 are provided on distinct nozzle members in Fig. 1, it is also allowable to clean only any one of the nozzle members in the cleaning step. With this also, the amount of the foreign matter in the liquid is decreased during the exposure to be performed thereafter. C2: In this embodiment, the differential evacuation is used, in which the gas is sucked in the atmosphere into which the cleaning liquid is jetted. Therefore, it is possible to efficiently recover the removed foreign matter.

It is also enough that the cleaning liquid is merely jetted to the nozzle member 30, without performing the differential evacuation. In order to enhance the cleaning effect, it is also appropriate to increase the temperature of the cleaning liquid. C3: The process includes the step of moving the measuring stage MST relative to the nozzle member 30 as shown in Fig. 13(C), while jetting the cleaning liquid from the side of the measuring stage MST toward a part or parts of the recovery port 24 or a part of parts of the supply ports 13, 14 of the nozzle member 30. Therefore, even when the jetting port 386a is provided at one position, it is possible to clean the entire surface of the nozzle member 30 which is wider than the above. It is also appropriate that a plurality of jetting ports are provided on the measuring table MTB. In this embodiment, the passage port (including at least one of the supply port and the recovery port) for the liquid 1 of the nozzle member 30 is cleaned. However, it is also allowable to clean the liquid contact area of the nozzle member 30, other than the passage port, (for example, the lower surface of the nozzle member 30 except for the mesh filter 25). In a case that a liquid trap surface (inclined surface), which captures the liquid 1 allowed to outflow to the outside of the recovery port, is formed, for example, on the lower surface surrounding the recovery port of the nozzle member 30 (surface directed toward the substrate P), the trap surface may be cleaned in the same manner as described above.

C4: The nozzle member 30 is arranged to surround the optical element 2 closest to the image plane of the projection optical system PL, and the mesh-shaped mesh filter 25 is provided on the recovery port 24 of the nozzle member 30; and the cleaning liquid is jetted to the entire surface of the mesh filter 25 in the cleaning step. Therefore, it is possible to efficiently remove the foreign matter adhered to the mesh filter 25. C5: In this embodiment, the type of the liquid 1 for the liquid immersion exposure is different from that of the cleaning liquid 301B. Therefore, it is possible to use, as the cleaning liquid 301B, a liquid having the high cleaning effect including the solvent, etc. It is also possible to use the liquid 1 itself as the cleaning liquid 301B. It is not necessarily indispensable to provide the sucking device 365A provided that any problem is not caused such as the scattering of the liquid, etc. during the cleaning described above.

### Method for Monitoring Contamination State of Nozzle Member 30

In the embodiment described above, the nozzle member 30 is cleaned, for example, during the maintenance. However, the contamination or pollution state of the recovery port 24 of the nozzle member 30, etc. may be monitored as follows. As a result of the monitoring, when the contamination state of the nozzle member 30 exceeds a predetermined allowable range, the nozzle member 30 may be cleaned by using the method of the embodiment described above. Upon monitoring the contamination state, the substrate, which has been cleaned, is previously stored in the substrate cassette (not shown) of the exposure apparatus EX shown in Fig. 1. The cleaned substrate may be a substrate which has been cleaned with the liquid supplied from the liquid supply section 11 or the cleaning liquid supply section 26 in the exposure apparatus EX, or may be a substrate which has been cleaned in the unillustrated coater/developer. The cleaned substrate is loaded on the substrate holder PH to perform the exposure by the liquid immersion method, and then the substrate is unloaded.

After that, the number of particles existing on the unloaded substrate is detected by using a sensor, etc. provided, for example, in the wafer loader system or the coater/developer. The increase or decrease in the number of particles brought about after the liquid immersion exposure for the cleaned substrate is monitored, for example, every time when a predetermined number of lots of substrates are exposed; and if the number of particles exceeds an allowable range, then it is regarded that the contamination of the nozzle member 30 is advanced, and the nozzle member 30 is cleaned. Accordingly, the nozzle member 30 can be cleaned at a proper timing. It is also enough that the substrate is merely moved along the movement locus (movement route) which is same as that used during the exposure, without performing the liquid immersion exposure. In this case, it is also allowable that any film such as a resist is not formed on the substrate. The substrate may be composed of a material other than silicon.

In this embodiment, the measuring stage MST is moved to move the cleaning liquid jetting port 386a and the nozzle member 30 relative to each other. However, the nozzle member 30 may be made movable; and the jetting port 386a and the nozzle member 30 may be moved relative to each other, over or above the measuring stage MST (or the substrate stage PST) which is allowed to stand still.

### Fourth Embodiment

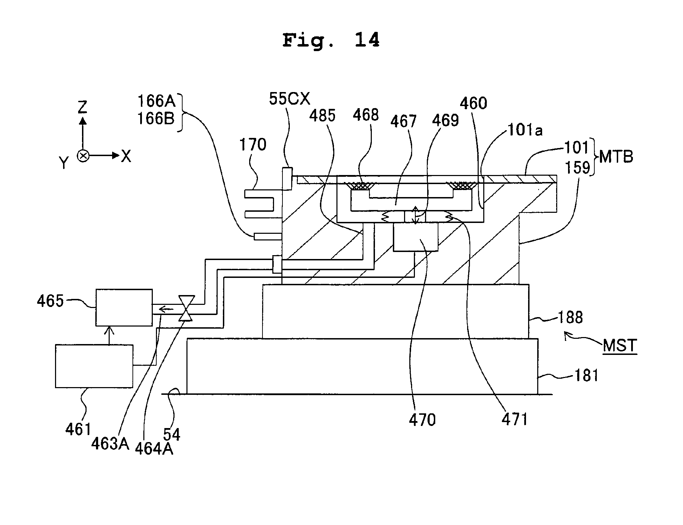

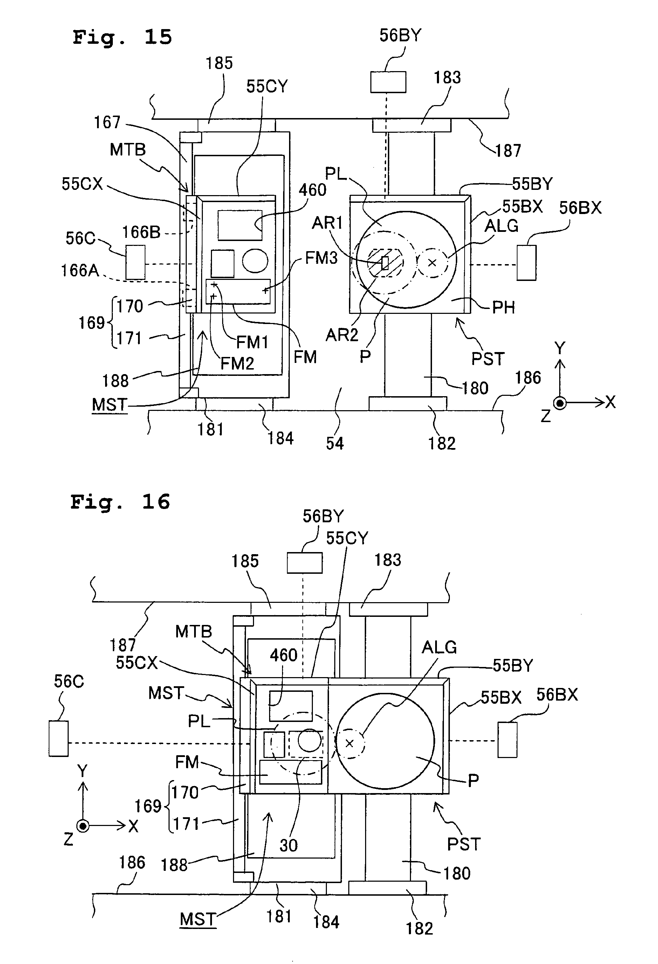

Next, the fourth embodiment of the present invention will be explained with reference to Figs. 14 to 17. Also in Figs. 14 to 17, the constitutive components or parts, which are the same as the constitutive components or parts described in the first embodiment, are designated by the same reference numerals, any explanation of which will be omitted. In this embodiment, the internal structure of the measuring table MTB and the cleaning step are different from those of the first embodiment. However, the exposure step of this embodiment is same as or equivalent to that of the first embodiment. An explanation will be made with reference to Figs. 14 and 15 about the structure of the measuring table MTB. As shown in Fig. 15, a pool portion 460, which is constructed of a substantially rectangular recess and which is provided to temporarily accommodate the cleaning liquid, is formed on the measuring table MTB. The pool portion 460 has a size which is slightly wider than the bottom surface of the nozzle member 30 shown in Fig. 3. As shown in Fig. 14, a cleaning liquid recovery section 465, which is provided to recover the cleaning liquid in the pool portion 460, is connected to the measuring table MTB. Further, the measuring table MTB is provided with a movable brush mechanism (cleaning member) in order to clean the nozzle member 30.

With reference to Fig. 14 illustrating the measuring table MTB in cross section, the pool portion 460 is the recess which is formed on the upper surface of the measuring table body 159. An opening 101a is also formed through the plate 101 in conformity with the size of the pool portion 460. A cleaning liquid flow passage 485 is formed to extend from the bottom surface of the pool portion 460 to a side surface of the measuring table body 159. The cleaning liquid recovery section 465 is connected to the flow passage 485 via a flexible piping 463A. As an example, the cleaning liquid recovery section 465 is provided with a vacuum system (sucking device) such as a vacuum pump, a tank for accommodating the recovered cleaning liquid, etc. Further, an opening/closing valve 464A is installed at an intermediate position of the piping 463A. A controller 461 controls the opening/closing operation of the valve 464A and the operation of the cleaning liquid recovery section 465. The controller 461 performs the recovery of the cleaning liquid from the pool portion 460 based on the control information from the controller CONT shown in Fig. 1.

A driving section 470 for upward/downward movement, which is of the voice coil motor system or the like, is installed at a central portion of the bottom surface of the pool portion 460. A rectangular flat plate-shaped brush frame 467 is supported, via a lifting shaft 469, by the driving section 470 controlled by the controller 461. A brush member 468 is fixed in an exchangeable state to a rectangular frame-shaped recess disposed at the circumferential edge portion of the brush frame 467. The brush member 468 is constructed, for example, by bundling a large number of fiber-like members which are flexible and which are formed of, for example, synthetic resin or nonwoven fabric. It is possible to quickly remove the dirt or contaminant (pollutant) by brushing an object (liquid contact portion) to which the dirt is adhered, with the brush member 468, without damaging the object. Further, the planar shape of the brush member 468 is approximately same as the planar shape of the frame-shaped mesh filter 25 which is in the nozzle member 30 shown in Fig. 3. The substantially entire surface of the mesh filter 25 can be covered with the brush member 468. The brush mechanism is constructed to include the brush member 468, the brush frame 467, the lifting shaft 469, and the driving section 470.

In this case, the lifting shaft 469 is moved downwardly during the ordinary exposure, and the brush member 468 is accommodated in the pool portion 460 so that the end portion of the brush member 468 is disposed at the position lower than that of the surface of the plate 101 of the measuring table MTB. On the other hand, upon cleaning the nozzle member 30 shown in Fig. 1, the lifting shaft 469 is moved upwardly by the driving section 470, and the end portion of the brush member 468 is disposed at a position higher than that of the plate 101. The brush member 468 is capable of coming into contact with the member which is the cleaning objective. Further, if necessary, the driving section 470 is also capable of vibrating the brush member 468 in the Z direction at a minute amplitude. Further, the brush member 468 can be vibrated in the X direction as well by vibrating the measuring table MTB in the X direction by the X axis voice coil motors 168A, 168X shown in Fig. 1. The cleaning liquid is allowed to inflow into the pool portion 460 as described later on. Therefore, the lifting shaft 469, etc. is tightly sealed by a bellows member 471, etc. in order to avoid any contact with the cleaning liquid. A part or parts of the cleaning mechanism of this embodiment may be substituted, for example, with an equipment of the factory or the like in which the exposure apparatus EX is installed.

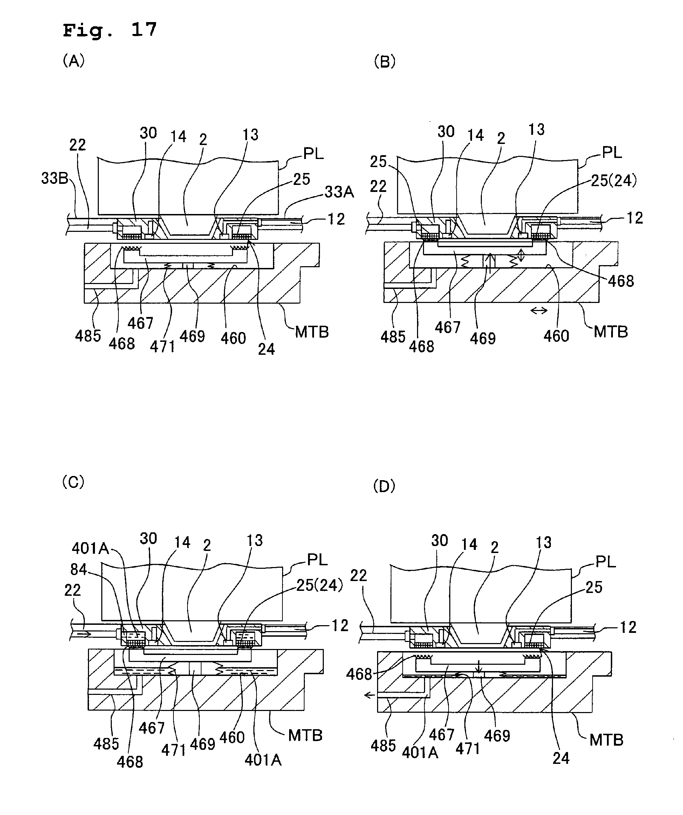

Next, the cleaning step in this embodiment will be explained with reference to Figs. 16 and 17. At first, after the exposure step is carried out in the same manner as in the first embodiment, the measuring table MTB of the measuring stage MST is allowed to be brought into tight contact with (or make approach closely to) the substrate holder PH disposed on the substrate stage PST as shown in Fig. 16 in a state that the radiation of the exposure light EL is stopped. Subsequently, the substrate stage PST and the measuring table MTB (measuring stage MST) are simultaneously moved in the +X direction to move the pool portion 460 on the measuring table MTB to the bottom surface of the projection optical system PL. After that, the substrate stage PST may be further retracted in the +X direction. As a result, as shown in Fig. 17(A), the pool portion 460 disposed on the measuring table MTB is moved to the bottom surface of the nozzle member 30 which is supported by the unillustrated column mechanism via the support members 33A, 33B (coated with the liquid-repellent coat) to surround the optical element 2 at the end portion of the projection optical system PL. In this state, the valve 463A shown in Fig. 14 is closed.

Subsequently, the lifting shaft 469 and the brush frame 467 are moved upwardly by the driving section 470 shown in Fig. 14. As shown in Fig. 17(B), the brush member 468 on the brush frame 467 is brought into tight contact with the substantially entire surface of the mesh filter 25 which covers the recovery port 24 of the nozzle member 30. In this state, the lifting shaft 469 is minutely vibrated in the Z direction, and the measuring table MTB is minutely vibrated in the X direction by the X axis voice coil motors 168A, 168B shown in Fig. 1. With this, the brush member 468 is vibrated in minute amounts in the Z direction and the X direction with respect to the mesh filter 25. Owing to the brushing operation performed by the brush member 468, the foreign matter adhered to the mesh filter 25 is removed to fall, or the foreign matter adheres to the brush member 468. Further, the brush member 468 may be brought into tight contact with areas including the supply ports 13, 14 of the nozzle member 30 to be minutely vibrated, and thus the foreign matter adhered to a portion in the vicinity of the supply ports 13, 14 may be removed.

Subsequently, the valve 23 shown in Fig. 1 is closed and the valve 28 shown in Fig. 1 is opened to supply a cleaning liquid 401A from the cleaning liquid supply section 26 via the supply tube 27, the recovery tube 22, and the recovery flow passage 84. As shown in Fig. 17(C), the cleaning liquid 401A is supplied into the recovery port 24 of the nozzle member 30. The supplied cleaning liquid 401A is allowed to pass through the mesh filter 25 and the brush member 468, and the cleaning liquid 401A is allowed to inflow into the pool portion 460 in a state that the cleaning liquid 401A contains the foreign matter. After that, the valve 28 shown in Fig. 1 is closed to stop the supply operation for the cleaning liquid 401A having been performed by the cleaning liquid supply section 26, and then the valve 464A shown in Fig. 14 is opened to recover the cleaning liquid in the pool portion 460 by the cleaning liquid recovery section 465 via the piping 463A and the flow passage 485. Accordingly, as shown in Fig. 17(D), the cleaning liquid 401A, which contains the foreign matter in the pool portion 460 of the measuring table MTB, is recovered by the cleaning liquid recovery section 465 shown in Fig. 14. If necessary, it is also appropriate to repeat the cleaning step ranging from Fig. 17(A) to Fig. 17(D) a plurality of times.

The function and the advantage of the cleaning step of this embodiment are summarized as follows.
D1: The area including the recovery port 24 of the nozzle member 30 is brushed with the flexible brush member 468 from the side of the measuring stage MST (measuring table MTB) in order to clean the nozzle member 30 as shown in Fig. 17(B). Therefore, the foreign matter, which is tightly adhered to the recovery port 24, can be efficiently removed. In this procedure, the brush member 468 is provided on the measuring table MTB. Therefore, it is possible to efficiently perform the maintenance for the liquid supply mechanism 10 and the liquid recovery mechanism 20 (as well as the maintenance for the exposure apparatus), for example, during the measurement of the baseline amount, without exerting any influence on the substrate stage PST on which the substrate P is held. As a result, the amount of the foreign matter is decreased in the liquid of the liquid immersion area AR2 on the substrate P in the exposure step to be performed thereafter. Therefore, the shape error of the pattern to be transferred, etc. is reduced, thereby making it possible to perform the exposure highly accurately.

It is allowable to use one brush member 468 or a plurality of brush members 468. The number and the size thereof are arbitrary. However, by adjusting the size of the brush member 468 to the size of the mesh filter 25, it is possible to efficiently clean the mesh filter 25. The brush member 468 can be also provided on the substrate stage PST (substrate holder PH). Accordingly, it is possible to simplify the construction of the stage (as well as the cleaning mechanism).

The brush member 468 may be used to brush the areas including the supply ports 13, 14 of the nozzle member 30. For example, with reference to Fig. 1, in a case that the liquid supply ports 13, 14 and the recovery port 24 are provided on distinct nozzle members, it is also allowable to clean only any one of the nozzle members in the cleaning step. With this also, the amount of the foreign matter in the liquid is also decreased during the exposure to be performed thereafter. D2: As shown in Fig. 17(B), the brush member 468 and the nozzle member 30 are vibrated relative to each other. Therefore, the foreign matter adhering tightly, for example, to the nozzle member 30 can be removed with ease. For example, the nozzle member 30 and/or the measuring table MTB may be driven to vibrate the nozzle member 30 and the brush member 468 relative to each other in the Z direction, instead of the procedure in which the brush member 468 is vibrated.

In this embodiment, as shown in Fig. 14, the driving section 470 is provided in order to drive the brush member 468 in the Z direction. However, also in this embodiment, the measuring table MTB is provided with the leveling table 188 in the same manner as the construction shown in Fig. 1. Accordingly, it is also possible to omit the driving section 470 by increasing the driving amount of the leveling table 188 in the Z direction. On the contrary, it is also possible to add, to the driving section 470, a vibrating mechanism to effect the vibration in the X direction or the Y direction. It is also possible to omit the driving section 470 by moving the nozzle member 30 in the -Z direction to come into contact with the brush member 468. In this case, it is also allowable to utilize an attaching/detaching mechanism (or an exchange mechanism) for the nozzle member 30.

D3: In this embodiment, the cleaning liquid 401A is also supplied to the recovery port 24 of the nozzle member 30 to perform the cleaning with the liquid continuously to the brushing step with the brush member 468. Therefore, it is possible to clean off the foreign matter removed from the nozzle member 30. D4: The nozzle member 30 is arranged to surround the optical element 2 closest to the image plane of the projection optical system PL, and the mesh filter 25 is provided on the recovery port 24 of the nozzle member 30. In the cleaning step described above, the substantially entire surface of the mesh filter 25 is brushed with the brush member 468. Therefore, it is possible to efficiently remove the foreign matter adhered to the mesh filter 25. In this embodiment, the passage port (including at least one of the supply port and the recovery port) for the liquid 1 of the nozzle member 30 is cleaned. However, it is also allowable to clean a liquid contact area of the nozzle member 30 other than the passage port.

D5: In this embodiment, the liquid 1 for the liquid immersion exposure is of the type different from that of the cleaning liquid 401A. Therefore, it is possible to use, as the cleaning liquid 401A, a liquid having the high cleaning effect including the solvent, etc. It is also possible to use the liquid 1 itself as the cleaning liquid 401A. In this case, the liquid supply section 11 shown in Fig. 1 can be also used as the cleaning liquid supply section 26 shown in Fig. 1. This makes it possible to simplify the construction of the liquid supply mechanism. In this embodiment, the cleaning liquid is supplied from the side of the nozzle member 30 toward the brush member 468. However, an unillustrated cleaning liquid supply mechanism may be used in combination with this or instead of this to allow the cleaning liquid to leak out from a gap of the brush member 468, for example, toward the mesh filter 25 of the nozzle member 30. Accordingly, it is possible to enhance the cleaning effect brought about by the brush member 468. A sucking device, which sucks, for example, the cleaning liquid and/or the foreign matter generated from a contact portion between the brush member 468 and the nozzle member 30, may be provided on the measuring table MTB. In this case, it is possible to avoid or suppress the contamination of the measuring table MTB, etc. due to the above-described cleaning (washing).

### First Modification of Fourth Embodiment

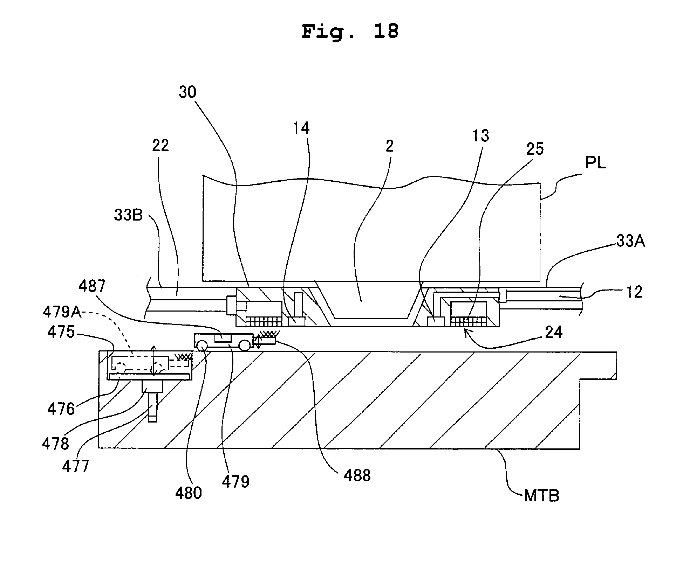

In the fourth embodiment, as shown in Fig. 17(A), the nozzle member 30 is cleaned (washed) by using the brush member 468 supported by the brush frame 467 which is movable upwardly and downwardly on the measuring table MTB of the measuring stage MST. Apart from this, as shown in Fig. 18, the nozzle member 30 may be cleaned by a brush member provided on a self-propelled robot. With reference to Fig. 18 illustrating components or parts corresponding to those shown in Fig. 17(A) designated by the same reference numerals, a housing recess 475 is formed on the upper surface of the measuring table MTB, and a support plate 476 is supported by a lifting shaft 477 at a central portion of the recess 475. The controller CONT shown in Fig. 1 moves the lifting shaft 477 upwardly and downwardly in the direction of the optical axis (optical axis direction) of the projection optical system PL (Z direction) via a driving section 478 shown in Fig. 18. Accordingly, the support plate 476 can be moved between the bottom surface of the recess 475 and a position in the vicinity of the upper surface of the measuring table MTB.

The self-propelled robot 479, which is installed with four small wheels 480 driven by an internal motor, is placed on the measuring table MTB. A brush member 488, which is small but constructed in the same manner as the brush member 468 shown in Fig. 17(A), is provided movably in the upward and downward directions, at the end portion of the self-propelled robot 479. The self-propelled robot 479 is movable in the X direction and the Y direction on the measuring table MTB in the wireless manner or via an unillustrated signal cable by being controlled, for example, by the controller CONT shown in Fig. 1. Upon cleaning the nozzle member 30, the movement route of the self-propelled robot 479 is set so that the brush member 488 is moved along the entire surface of the rectangular frame-shaped recovery port 24 (mesh filter 25). Further, an image pickup device 487 is fixed to an upper portion of the self-propelled robot 479. An image data, which is obtained by the image pickup device 487, is displayed on an unillustrated display, so that an operator can confirm the position of the recovery port 24 (mesh filter 25) of the nozzle member 30. Thus, it is possible to correct the movement route of the self-propelled robot 479 based on an obtained result of the confirmation.

During the ordinary exposure and the measurement in the first modification, the self-propelled robot 479 is moved onto the support plate 476, and the self-propelled robot 479 is accommodated at the position 479A in the recess 475. Upon cleaning the nozzle member 30, then the support plate 476 is moved upwardly, and the self-propelled robot 479 is moved to the upper surface of the measuring table MTB. Concurrently with this, the measuring stage MST (measuring table MTB) is moved to the lower surface of the nozzle member 30, and the measuring table MTB is allowed to stand still. Subsequently, the brush member 488 of the self-propelled robot 479 is moved upwardly until arrival at a height at which the brush member 488 is capable of coming into contact with the nozzle member 30. After that, the self-propelled robot 479 is driven to brush and clean the mesh filter 25 of the nozzle member 30 by the brush member 488. During this process or after this process, the cleaning liquid is supplied into the nozzle member 30 from the cleaning liquid supply section 26 shown in Fig. 1, and the foreign matter in the mesh filter 25 is made to enter into and mix with or made to be dissolved in the cleaning liquid. After that, as an example, the liquid recovery section 21 shown in Fig. 1 is operated to recover the cleaning liquid.

The liquid 1 for the liquid immersion may be supplied from the liquid supply section 11 shown in Fig. 1, instead of supplying the cleaning liquid as described above. After that, the brush member 488 is moved downwardly, and then the self-propelled robot 479 is accommodated at the position 479A in the recess 475 again. It is also possible to efficiently clean the nozzle member 30 by moving the brush member 488 and the nozzle member 30 relative to each other by using the self-propelled robot 479 as described above. According to this modification, even when the shape of, for example, the recovery port 24 of the nozzle member 30 is changed, it is possible to perform the cleaning by using the same self-propelled robot 479.

### Second Modification of Fourth Embodiment

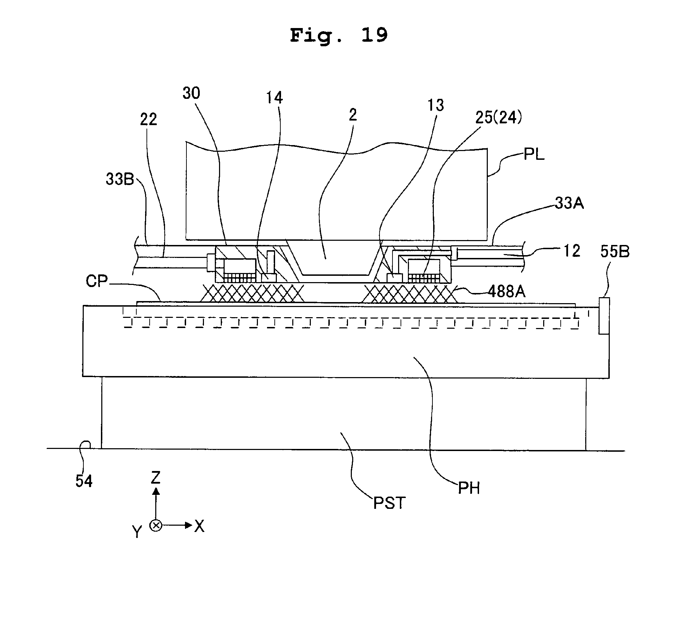

As shown in Fig. 19, a dummy substrate CP, which is not coated with the resist although the outer shape is the same as that of the substrate P as the exposure objective, may be prepared beforehand; and a brush member 488A, which has a shape to cover the entire surface of the recovery port 24 and/or the supply ports 13, 14 on the lower surface of the nozzle member 30, may be previously provided on the upper surface of the dummy substrate CP. Upon cleaning the nozzle member 30 in this modification, the dummy substrate CP is loaded, instead of the substrate as the exposure objective, on the substrate holder PH on the substrate stage PST. In this procedure, the height of the brush member 488A is previously adjusted so that the upper end of the brush member 488A approximately comes into contact with the lower surface of the nozzle member 30 in a state that the Z position of the upper surface of the substrate holder PH is most lowered via the Z stage of the substrate stage PST.

After that, the Z stage is driven to move the brush member 488A of the dummy substrate CP upwardly to thereby bring the end portion of the brush member 488A to sufficiently into contact with the lower surface of the nozzle member 30, especially with the mesh filter 25, and then the substrate stage PST is slightly vibrated in the X direction and the Y direction. In this process or after this process, the cleaning liquid is supplied into the nozzle member 30 from the cleaning liquid supply section 26 shown in Fig. 1, so as to make the foreign matter of the mesh filter 25 enter into and mix with (be dissolved in) the cleaning liquid. After that, as an example, the liquid recovery section 21 shown in Fig. 1 is operated to recover the cleaning liquid. The liquid 1 for the liquid immersion may be supplied from the liquid supply section 11 shown in Fig. 1, instead of supplying the cleaning liquid as described above. After that, the dummy substrate CP is unloaded. The nozzle member 30 can be also cleaned efficiently by moving the brush member 488A of the dummy substrate CP relative to the nozzle member 30 as described above. According to this modification, it is unnecessary to provide any cleaning mechanism for the stage system of the exposure apparatus. It is possible to suppress the production cost of the exposure apparatus to be low. Any other brushing or polishing member may be provided on the dummy substrate CP instead of the brush member 488A.

### Fifth Embodiment

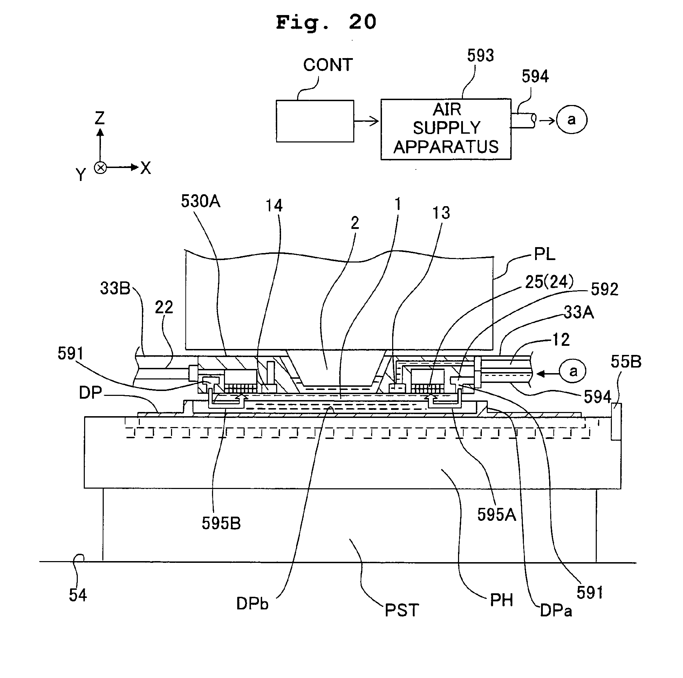

Next, the fifth embodiment of the present invention will be explained with reference to Fig. 20. In Fig. 20, the components or parts, which correspond to those shown in Fig. 1, are designated by the same reference numerals, any detailed explanation of which will be omitted. Fig. 20 shows an construction of the substrate stage PST and a lower portion of the projection optical system PL of an exposure apparatus of this embodiment. With reference to Fig. 20, a ring-shaped nozzle member 530A is installed as a liquid immersion space-forming member to surround the optical element 2 which is disposed at the lowermost end of the projection optical system PL. The substrate as the exposure objective is loaded on the substrate holder PH during the exposure based on the liquid immersion method. The liquid 1, which is supplied from a liquid supply mechanism that is the same as or equivalent to the liquid supply mechanism 10 shown in Fig. 1, is supplied onto the substrate via supply ports 13, 14 of the nozzle member 530A.

Concurrently with this, or if necessary, the liquid 1 is recovered by a liquid recovery mechanism which is the same as or equivalent to the liquid recovery mechanism 20 shown in Fig. 1 from a rectangular frame-shaped recovery port 24 (installed with the mesh filter 25) formed on the nozzle member 530A to surround the supply ports 13, 14. In this embodiment, a gas such as the air, from which the dust is removed to the utmost extent and which is temperature-adjusted, is supplied intermittently at a predetermined flow rate from an external air supply apparatus 593 via a piping 594, a ventilation hole 592 which is provided in the nozzle member 530A, and a blow port 591 which is rectangular (or may be circular, etc.) and which is formed on the lower surface of the nozzle member 530A to surround the recovery port 24. In this case, the liquid immersion space, in which the liquid 1 is locally filled between the nozzle member 530A and the substrate as the exposure objective, is maintained by the gas (air curtain) supplied from the blow port 591.

In a case that the nozzle member 530A is cleaned in this embodiment, as shown in Fig. 20, a dummy substrate DP, which has a shape approximately same as that of the substrate as the exposure objective and which is not coated with the resist, is loaded on the substrate holder PH, instead of the substrate as the exposure objective. A ring-shaped protrusion DPa, which has a size to cover the liquid immersion space to be provided when the liquid immersion exposure is performed, is formed on the upper surface of the dummy substrate DP. The upper surface DPb, which is disposed inside the protrusion DPa, is covered with, for example, a liquid-repellent porous member. In this state, the liquid 1 is supplied to the inside of the protrusion DPa of the dummy substrate DP from the supply ports 13, 14 of the nozzle member 530A, and gas 595A, 595B is supplied from the blow port 591.

In this situation, the gas 595A, 595B is blocked by the protrusion DPa. Therefore, the gas 595A, 595B is allowed to flow toward the recovery port 24 (mesh filter 25) disposed at the inside of the protrusion DPa. Further, a large amount of minute bubbles enters into and mixes with the gas 595A, 595B, as the gas 595A, 595B is allowed to pass across the porous upper surface DPb. Therefore, the cleaning effect is enhanced by the minute bubbles. Therefore, the foreign matter, which is adhered especially to the mesh filter 25, is made to enter into and mix with or to be eluted in the liquid 1. After that, the liquid 1 is recovered to the liquid recovery mechanism from the recovery port 24 via the recovery tube 22. Further, the liquid 1, remaining at the inside of the protrusion DPa of the dummy substrate DP, is unloaded to the outside together with the dummy substrate DP.

As described above, according to this embodiment, the gas is supplied approximately to the side of the recovery port 24 of the nozzle member 530A via the liquid 1 from the gas supply mechanism including the air supply apparatus 593 and the piping 594. Therefore, it is possible to efficiently clean the mesh filter 25 installed in the recovery port 24. In this procedure, since the upper surface DPb of the dummy substrate DP is porous, a high cleaning effect is obtained. A flat plate-shaped dummy substrate may be loaded instead of the dummy substrate DP. Even in this case, a relatively high cleaning effect is obtained owing to the flow of the gas.

### Sixth Embodiment

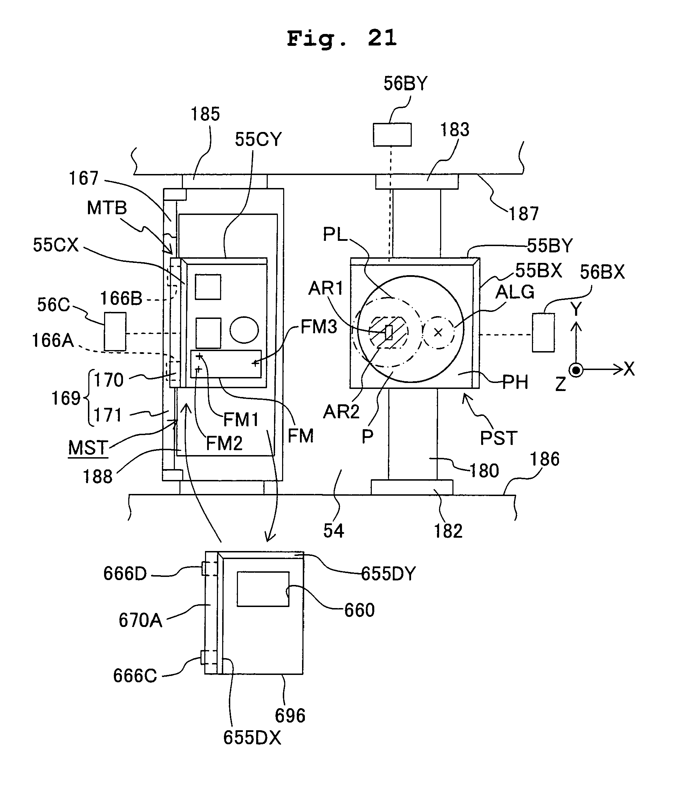

Next, the sixth embodiment of the present invention will be explained with reference to Fig. 21. In Fig. 21, the components or parts, which correspond to those shown in Figs. 5 and 6, are designated by the same reference numerals, any detailed explanation of which will be omitted. Fig. 21 shows a stage system including the substrate stage PST and the measuring stage MST of an exposure apparatus of this embodiment. With reference to Fig. 21, a measuring table MTB of the measuring stage MST is constructed so that the measuring table MTB is exchangeable with a multi-purpose tool table 696 (movable member) which is placed externally or at the outside by an unillustrated exchange mechanism. Those fixed to the tool table 696, in the same manner as the measuring table MTB, include an X axis reflecting mirror 655DX, a Y axis reflecting mirror 655DY, a mover 670A which is equivalent to the mover 170, and movers 666C, 666D which are equivalent to the movers 166A, 166B. Therefore, in a case that the measuring table MTB is exchanged with the tool table 696, the position of the tool table 696 can be measured by the laser interferometers 56C, 56BY. Further, the position and the angle of rotation of the tool table 696 can be controlled, in the same manner as the measuring table MTB, by a Y axis linear motor which is constructed of the mover 670A of the tool table 696 and the stator 171 of the measuring stage MST and an X axis actuator which is constructed of the movers 666C, 666D of the tool table 696 and the stator 167 of the measuring stage MST.

With reference to Fig. 21, a pool portion 660 is formed on the tool table 696. A brush mechanism (not shown), which is equivalent to the brush member 468 shown in Fig. 14, is installed or disposed in the pool portion 660. A mechanism for discharging the liquid in the pool portion 660 and a control system for driving the brush mechanism are also provided. Therefore, the nozzle member 30 can be cleaned, in the same manner as in the fourth embodiment shown in Fig. 17, by moving the pool portion 660 of the tool table 696 to the bottom surface of the nozzle member 30 under or below the projection optical system PL.

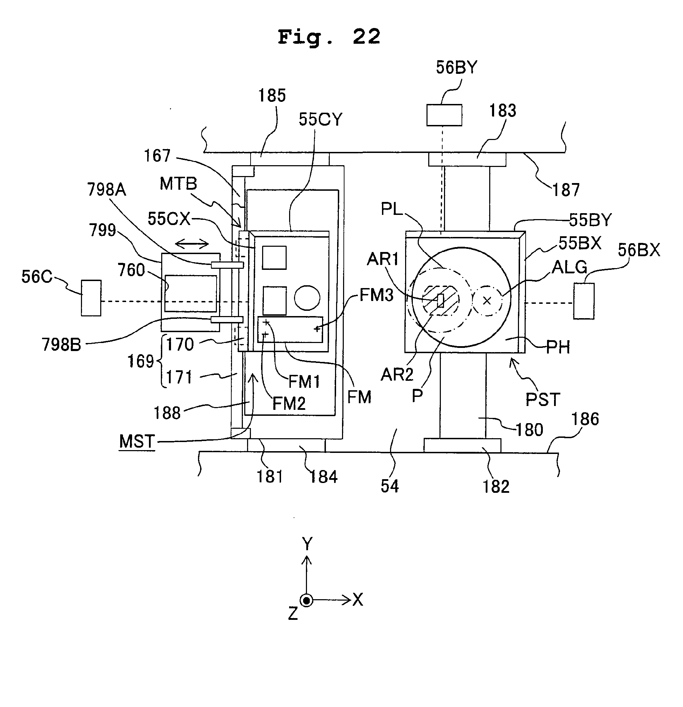

Alternatively, as shown in Fig. 22, a multi-purpose tool stage 799 may be connected to the measuring table MTB of the measuring stage MST via connecting members 798A, 798B, instead of using the tool table 696 exchangeable with the measuring table MTB as described above. In this modification, a pool portion 760 is formed on the tool stage 799. A brush mechanism (not shown), which is equivalent to the brush member 468 shown in Fig. 14, is installed in the pool portion 760; and a mechanism for discharging the liquid in the pool portion 760 and a control system for driving the brush mechanism are also provided. Therefore, by driving the measuring stage MST to move the pool portion 760 of the tool stage 799 to the bottom surface of the nozzle member 30 under or below the projection optical system PL, it is possible to clean the nozzle member 30 and to execute the maintenance for the exposure apparatus in the same manner as in the fourth embodiment shown in Fig. 17. In this modification, it is unnecessary to provide any exchange mechanism.

In this embodiment, the following construction is also available in order to move, for example, the brush member 468 and the nozzle member 30 relative to each other. That is, the nozzle member 30 is made movable, and the nozzle member 30 is moved with respect to the brush member 468 which is allowed to stand still. In this embodiment, the cleaning mechanism, which is provided on the tool table 696 or the tool stage 799, is not limited to the brush mechanism of the fourth embodiment. It is also allowable to use any cleaning mechanism of any other embodiment.

In the first to sixth embodiments and the modifications thereof described above, the measuring stage MST includes, as the measuring members, the reference mark and at least one of the plurality of measuring devices described above, in addition to the cleaning mechanism. However, the type and/or the number, etc. of the measuring member or members to be provided on the measuring stage MST is not limited to this. As for the measuring member, it is also allowable to provide, for example, a transmittance measuring device for measuring the transmittance of the projection optical system PL. Only a part or parts of the measuring devices may be provided on the measuring stage MST, and the remaining part may be provided at the outside of the measuring stage MST. Further, at least one measuring device may be provided on the substrate stage PST.

In the first to sixth embodiments and the modifications thereof described above, at least a part of the cleaning mechanism is provided on the measuring stage MST. However, at least a part of the cleaning mechanism may be provided on a movable stage (movable member, movable body, movable element) which is independent from the measuring stage MST. The movable stage may be the substrate stage PST. In this case, for example, in the second embodiment, the driving section (268A, 268B) for the stirring bar may be embedded in the substrate stage PST. In the third embodiment, the jetting port 386a for the cleaning liquid may be provided on the substrate stage PST. The movable stage may be different from the substrate stage PST. In this case, for example, in order to maintain the liquid immersion area AR2 described above during the exchange of the substrate P, the movable stage may be arranged to be opposite to or face the projection optical system PL by being exchanged with the substrate stage PST.

In the first to sixth embodiments and the modifications thereof described above, the nozzle member 30 is cleaned by the cleaning mechanism described above. However, the cleaning objective is not limited to the nozzle member 30, and may be any other liquid contact portion (for example, the optical element 2) which comes into contact with the liquid 1. In the respective embodiments and the modifications thereof described above, for example, the liquid contact portion may be subjected to the bubble cleaning by using the liquid 1, into which the bubbles (air bubbles) entered and mixed therewith, as the liquid for the cleaning. Further, when the liquid is used to clean the liquid contact portion in the respective embodiments and the modifications thereof described above, the cleaning operation may be monitored by using a measuring device including, the above-described particle monitor, etc.

In the respective embodiments and the modifications thereof described above, the interferometer system (56A to 56C) is used to measure the position information about each of the mask stage RST, the substrate stage PST, and the measuring stage MST. However, there is no limitation to this. For example, it is also allowable to use an encoder system for detecting a scale (diffraction grating) provided on each of the stages. In this case, it is preferable that a hybrid system having both of the interferometer system and the encoder system is provided, and the measurement result of the encoder system is calibrated (subjected to the calibration) by using the measurement result of the interferometer system. The position control of the stage may be performed by switchingly using the interferometer system and the encoder system or using both of the interferometer system and the encoder system.

In the respective embodiments described above, the substrate holder PH may be formed as an integrated body with the substrate stage PST. Alternatively, the substrate holder PH and the substrate stage PST may be constructed separately, and the substrate holder PH may be fixed to the substrate stage PST, for example, by the vacuum attraction.
The present invention is also applicable to an exposure apparatus in which various measuring devices are provided on the substrate stage PST (exposure apparatus not provided with the measuring stage MST). Only a part or parts of various measuring devices may be provided on the measuring stage MST or the substrate stage PST, and the remaining part may be provided at the outside or on any distinct member.

The present invention has been explained by using the first to sixth embodiments and the modifications thereof. However, the embodiments may be appropriately combined. For example, the first embodiment and the second embodiment can be combined with each other. In this case, the driving sections 268A, 268B for the stirring bars may be embedded under or below the bottom surface of the pool portion 60 of the measuring table MTB, or may be provided other portions. The exposure apparatus of the first embodiment can be combined with the exposure apparatus of the fourth embodiment. In this case, the mesh filter 25 of the nozzle member 30 can be cleaned with the brush member 468 after performing the cleaning of the nozzle member 30 with the cleaning liquid of the pool portion 60 of the measuring table MTB or while performing the cleaning. Further, the exposure apparatus of the third embodiment can be combined with the exposure apparatus of the fourth embodiment. In this case, the pool portion 60 and the brush member 468 may be provided on the measuring stage MST provided with the sucking port and the jetting port formed on the measuring table body 159 as described in the third embodiment. In this case, the cleaning may be performed with the brush member 468 after jetting the cleaning liquid from the jetting port, and then the cleaning liquid may be jetted again.

The cleaning steps, which have been explained by using the first to sixth embodiments and the modifications thereof, may be appropriately combined and used. For example, the cleaning step of each of the second to sixth embodiments and/or the modifications thereof can be appropriately carried out after carrying out the cleaning step of the first embodiment. The cleaning effect of the nozzle member may be confirmed after carrying out the cleaning step of the first embodiment; and depending on an obtained result thereof, the jetting of the cleaning liquid (third embodiment) and the cleaning with the brush member (fourth embodiment) may be carried out. In this case, it is convenient to use the tool stage explained in the first modification of the fourth embodiment.

In the respective embodiments and the modifications described above, the liquid 1 to be used as the liquid immersion method is water. However, it is also allowable to use any liquid other than water. For example, in a case that the light source of the exposure light EL is the F₂ laser (wavelength: 157 nm), the liquid 1 may be, for example, fluorine-based fluids such as fluorine-based oil and perfluoropolyether (PFPE). Alternatively, other than the above, it is also possible to use, as the liquid 1, those (for example, cedar oil) which have the transmittance with respect to the exposure light EL, which have the refractive index as high as possible, and which are stable against the resist coated on the surface of the substrate P and the projection optical system PL. Those having refractive indexes higher than those of silica glass and calcium fluoride (refractive index of about 1.6 to 1.8) may be used as the liquid 1. Further, the optical element 2 may be formed of a material having a refractive index (for example, not less than 1.6) higher than those of silica glass and calcium fluoride.

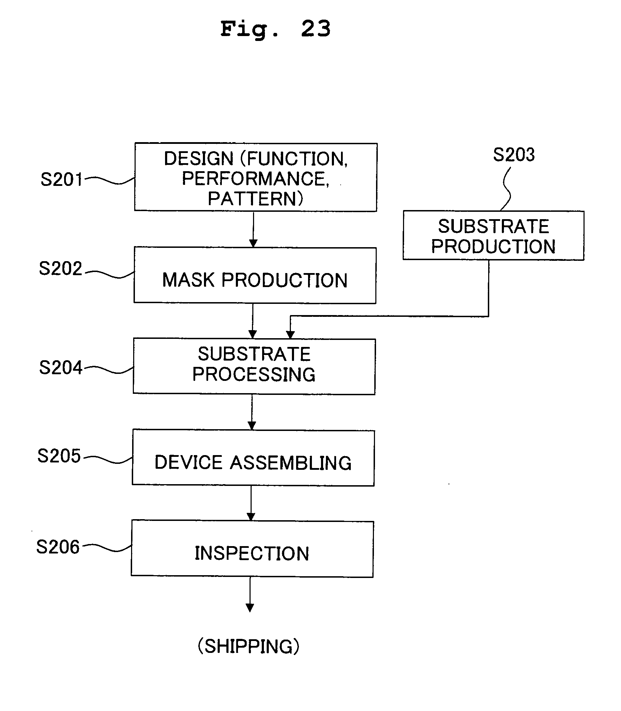

As shown in Fig. 23, a microdevice such as the semiconductor device is produced and shipped by performing a step (S201) of designing the function and the performance of the microdevice; a step (S202) of manufacturing a mask (reticle) based on the designing step; a step (S203) of producing a substrate as a base material for the device; a substrate-processing step (S204) including, for example, a step of exposing the substrate with the pattern of the mask by the exposure apparatus EX of the embodiment described above, a step of developing the exposed substrate, and a step of heating (curing) and etching the developed substrate; a step (S205) of assembling the device (including processing processes such as a dicing step, a bonding step, and a packaging step); an inspection step; and the like.

In the respective embodiments and the modifications described above, the substrate P is not limited only to a semiconductor wafer for producing a semiconductor device. Those applicable include, for example, a glass substrate for a display device, a ceramic wafer for a thin film magnetic head, a master plate (synthetic silica glass, silicon wafer) for the mask or the reticle to be used for the exposure apparatus, and a film member, etc. Further, the shape of the substrate P is not limited only to the circular shape, and may be any other shape including rectangular shapes, etc. In the respective embodiments and the modifications described above, the mask, on which the transferring pattern is formed, is used. However, instead of such a mask, it is also allowable to use an electronic mask for forming a transmissive pattern or a reflective pattern based on an electronic data of the pattern to be subjected to the exposure as disclosed, for example, in United States Patent No. 6,778,257. The electronic mask is also referred to as "variable shaped mask" ("active mask", or "image generator"), which includes, for example, DMD (Digital Micro-mirror Device) as one of the no light-emitting image display device (spatial light modulator). DMD has a plurality of reflecting elements (micro-mirrors) which are driven based on a predetermined electronic data. The plurality of reflecting elements are arranged in a two-dimensional matrix form on a surface of DMA, and are driven individually (element by element) to reflect and deflect the exposure light. Angle of the reflecting surface of each of the reflecting elements is adjusted. The operation of DMD may be controlled by the controller CONT. The controller CONT drives the reflecting elements of DMD based on the electronic data (pattern information) corresponding to the pattern to be formed on the substrate P, and the exposure light radiated by the illumination system IL is patterned by the reflecting elements. By using DMD, it is unnecessary to perform the exchange operation for the mask and the alignment operation for the mask on the mask stage when the pattern is changed, as compared with a case in which the exposure is performed by using the mask (reticle) formed with the pattern. Therefore, it is possible to perform the exposure operation more efficiently. In the case of the exposure apparatus using the electronic mask, it is enough that the substrate is merely moved in the X axis direction and the Y axis direction by the substrate stage, without providing the mask stage. The exposure apparatus using DMD is disclosed, for example, in Japanese Patent Application Laid-open Nos. 8-313842 and 2004-304135 in addition to the above-identified United States Patent No. 6,778,257. The contents of United States Patent No. 6,778,257 is incorporated herein by reference within a range of permission of the domestic laws and ordinances of the designated state or the selected state.

As for the exposure apparatus EX, the present invention is also applicable to a scanning type exposure apparatus (scanning stepper) based on the step-and-scan system for performing the scanning exposure with the pattern of the mask M by synchronously moving the mask M and the substrate P as well as to a projection exposure apparatus (stepper) based on the step-and-repeat system for performing the full field exposure with the pattern of the mask M in a state that the mask M and the substrate P are allowed to stand still, while successively step-moving the substrate P.

It is not necessarily indispensable that the exposure apparatus of the present invention and the exposure apparatus to which the maintenance method and the exposure method of the present invention are applied are provided with the projection optical system. It is enough that the exposure apparatus is provided with an optical member for guiding the exposure light from the light source to the substrate within a range in which the present invention can be carried out. It is also allowable that the illumination optical system and/or the light source is/are provided separately from the exposure apparatus. It is also possible to omit the mask stage and/or the substrate stage depending on the exposure system as described above.

As for the type of the exposure apparatus EX, the present invention is not limited to the exposure apparatus for the semiconductor device production for exposing the substrate P with the semiconductor device pattern. The present invention is also widely applicable, for example, to an exposure apparatus for producing the liquid crystal display device or for producing the display as well as an exposure apparatus for producing a thin film magnetic head, a micromachine, MEMS, a DNA chip, an image pickup device (CCD), a reticle, a mask, etc.

The present invention is also applicable to an exposure apparatus of the multi-stage type provided with a plurality of substrate stages as disclosed, for example, in Japanese Patent Application Laid-open No. 10-163099, Japanese Patent Application Laid-open No. 10-214783 (corresponding to United States Patent Nos. 6,341,007, 6,400,441, 6,549,269, and 6,590,634), Published Japanese Translation of PCT International Publication for Patent Application No. 2000-505958 (corresponding to United States Patent No. 5,969,441), and United States Patent No. 6,208,407. In this case, the cleaning is carried out for the plurality of substrate stages respectively. The contents of the United States Patents identified above are incorporated herein by reference within a range of permission of the domestic laws and ordinances of the designated state or the selected state in relation to the exposure apparatus of the multi-stage type.

In the case of the projection optical system of each of the embodiments and the modifications described above, the optical path space (liquid immersion space), which is disposed on the image plane side of the optical element arranged at the end portion of the projection optical system, is filled with the liquid. However, it is also possible to adopt a projection optical system in which the optical path space disposed on the mask side of the optical element arranged at the end portion is also filled with the liquid, as disclosed, for example, in International Publication No. 2004/019128. Further, the present invention is also applicable to an exposure apparatus of the liquid immersion type in which the liquid immersion area between the projection optical system and the substrate is held or retained by an air curtain arranged therearound. The present invention is also applicable to an exposure apparatus in which a line-and-space pattern is formed on the substrate P by forming interference fringes on the substrate P as disclosed, for example, in International Publication No. 2001/035168. Also in this case, the exposure light is irradiated onto the substrate P through the liquid between the optical member and the substrate P.

In the respective embodiments and the modifications thereof described above, it is not necessarily indispensable that the liquid supply section and/or the liquid recovery section is/are provided on the exposure apparatus. For example, the equipment of the factory or the like in which the exposure apparatus is installed may be substitutively used. The structures of the exposure apparatus and the attached equipment required for the liquid immersion exposure are not limited to the structures as described above. It is possible to use those described, for example, in European Patent Publication No. 1420298, International Publication Nos. 2004/055803 and 2004/057590, International Publication No. 2005/029559 (corresponding to United States Patent application publication No. 2006/0231206), International Publication No. 2004/086468 (corresponding to United States Patent application publication No. 2005/0280791), and Japanese Patent Application Laid-open No. 2004-289126 (corresponding to United States Patent No. 6,952,253). The contents of, for example, the United States Patents and United States Patent application publications identified above are incorporated herein by reference within a range of permission of the domestic laws and ordinances of the designated state or the selected state in relation to the liquid immersion mechanism of the liquid immersion exposure apparatus and any apparatus equipped thereto.

In the respective embodiments and the modifications thereof described above, it is also allowable to use, as the liquid 1 to be used for the liquid immersion method, a liquid having the refractive index with respect to the exposure light higher than that of water, for example, those having the refractive index of about 1.6 to 1.8. The liquid 1, which has the refractive index (for example, not less than 1.5) higher than that of pure or purified water, includes, for example, predetermined liquids having the C-H bond or the O-H bond such as isopropanol having a refractive index of about 1.50 and glycerol (glycerin) having a refractive index of about 1.61, predetermined liquids (organic solvents) such as hexane, heptane, and decane, and decalin (decahydronaphthalene) having a refractive index of about 1.60. As for the liquid 1, it is also allowable to use those obtained by mixing arbitrary two or more liquids of the foregoing liquids, and it is also allowable to use those obtained by adding (mixing) at least one of the foregoing liquids to (with) pure water. Further, as for the liquid 1, it is also allowable to use those obtained by adding (mixing) base or acid such as H⁺, Cs⁺, K⁺, Cl⁻, SO₄²⁻, and PO₄²⁻ to (with) pure water, and it is also allowable to use those obtained by adding (mixing) fine particles of Al oxide or the like to (with) pure water. As for the liquid 1, it is preferable to use those which have a small coefficient of light absorption, which have a small temperature dependency, and which are stable against the photosensitive material (or, a top coat film or an antireflection film, etc.) coated to the surface of the substrate P and/or the projection system PL. As for the liquid 1, it is also possible to use a supercritical fluid. As for the substrate P, it is possible to provide, for example, the top coat film which protects the photosensitive material and the base material from the liquid.

On the other hand, the optical element (terminal end optical element) 2 of the projection optical system PL may be formed of, for example, silica glass (silica) or a single crystal material of any fluorine compound such as barium fluoride, strontium fluoride, lithium fluoride, and sodium fluoride, instead of calcium fluoride. Alternatively, the optical element (terminal end optical element) 2 may be formed of a material having a refractive index (for example, not less than 1.6) higher than those of silica glass and calcium fluoride. Those usable as the material having the refractive index of not less than 1.6 include sapphire, germanium dioxide, etc. as disclosed, for example, in International Publication No. 2005/059617, and potassium chloride (refractive index: about 1.75) as disclosed in International Publication No. 2005/059618, etc.

When the liquid immersion method is used, it is also allowable that the optical path disposed on side of the object plane (object plane side) of the terminal end optical element is also filled with the liquid, in addition to the optical path disposed on the image plane side of the terminal end optical element as disclosed, for example, in International Publication No. 2004/019128 (corresponding to United States Patent application publication No. 2005/0248856). Further, a thin film, which has the lyophilic or liquid-attractive property and/or the anti-dissolution function, may be formed on a part (including at least the contact surface which comes into contact with the liquid) or all of the surface of the terminal end optical element. The silica glass has a high affinity for the liquid, and any anti-dissolution film is not required for the silica glass as well. However, for calcium fluoride, it is preferable to form at least the anti-dissolution film.

In the respective embodiments described above, the ArF excimer laser is used as the light source for the exposure light EL. However, it is also allowable to use a high harmonic wave-generating device which includes, for example, a solid laser light source such as a DFB semiconductor laser or a fiber laser, a light-amplifying section having a fiber amplifier or the like, and a wavelength-converting section and which outputs a pulse light beam having a wavelength of 193 nm as disclosed, for example, in International Publication No. 1999/46835 (corresponding to United States Patent No. 7,023,610). Further, in the respective embodiments described above, the projection area (exposure area) is rectangular. However, it is also allowable to adopt any other shape including, for example, circular arc-shaped, trapezoidal, parallelogramic, and rhombic shapes.

Further, the present invention is also applicable, for example, to an exposure apparatus in which patterns of two masks are combined on the substrate via the projection optical system, and one shot area on the substrate is subjected to the double exposure substantially simultaneously by one time of the scanning exposure as disclosed, for example, in Published Japanese Translation of PCT International Publication for Patent Application No. 2004-519850 (corresponding to United States Patent No. 6,611,316). As described above, the present invention is not limited to the foregoing embodiments and the modifications, and may be embodied in other various forms within a range without deviating from the gist or essential characteristics of the present invention.

As described above, the exposure apparatus EX according to the embodiment of the present invention is produced by assembling the various subsystems including the respective constitutive elements as defined in claims so that the predetermined mechanical accuracy, electric accuracy and optical accuracy are maintained. In order to secure the various accuracies, those performed before and after the assembling include the adjustment for achieving the optical accuracy for the various optical systems, the adjustment for achieving the mechanical accuracy for the various mechanical systems, and the adjustment for achieving the electric accuracy for the various electric systems. The steps of assembling the various subsystems into the exposure apparatus include, for example, the mechanical connection, the wiring connection of the electric circuits, and the piping connection of the air pressure circuits in correlation with the various subsystems. It goes without saying that the steps of assembling the respective individual subsystems are performed before performing the steps of assembling the various subsystems into the exposure apparatus. When the steps of assembling the various subsystems into the exposure apparatus are completed, the overall adjustment is performed to secure the various accuracies as the entire exposure apparatus. It is desirable that the exposure apparatus is produced in a clean room in which the temperature, the cleanness, etc. are managed.

As for various United States Patents and United States Patent Application Publications referred to in this specification, the contents thereof are incorporated herein by reference within a range of permission of the domestic laws and ordinances of the designated state or the selected state, in relation to those other than those having been specifically and explicitly incorporated herein by reference as well.

### INDUSTRIAL APPLICABILITY

According to the present invention, it is possible to efficiently perform the maintenance for the exposure apparatus for performing the exposure in accordance with the liquid immersion method. Therefore, the amount of the foreign matter in the liquid of the liquid immersion area is decreased during the exposure to be performed thereafter, and it is possible to produce the device highly accurately. Therefore, the present invention can remarkably contribute to the development of the precision mechanical equipment industry including the semiconductor industry of our country.

## Claims

1. A maintenance method for an exposure apparatus which forms a liquid immersion space by filling, with a first liquid, a space between an optical member and a substrate held by a substrate stage and exposes the substrate with an exposure light via the optical member and the first liquid, the maintenance method comprising:
a moving step of arranging a movable stage which is movable independently from the substrate stage to be opposite to a liquid immersion space-forming member which forms the liquid immersion space with the first liquid; and
a cleaning step of cleaning the liquid immersion space-forming member by supplying a second liquid to a space between the liquid immersion space-forming member and the movable stage.

2. The maintenance method according to claim 1, wherein the movable stage includes a measuring stage which has a measuring member.

3. The maintenance method according to claim 1 or 2, wherein the exposure apparatus further comprises a projection optical system, and the optical member is a part of the projection optical system.

4. The maintenance method according to any one of claims 1 to 3, wherein at least a passage port, for the first liquid, of the liquid immersion space-forming member is cleaned in the cleaning step.

5. The maintenance method according to claim 4, wherein the passage port includes at least one of a supply port and a recovery port, for the first liquid, of the liquid immersion space-forming member.

6. The maintenance method according to claim 4 or 5, wherein at least a mesh-shaped filter member, which is provided on the passage port, is cleaned.

7. The maintenance method according to any one of claims 1 to 3, wherein at least a mesh-shaped filter member of the liquid immersion space-forming member is cleaned in the cleaning step.

8. The maintenance method according to any one of claims 1 to 7, wherein at least a part of the liquid immersion space-forming member which comes into contact with the first liquid is immersed in the second liquid in the cleaning step.

9. The maintenance method according to claim 8, wherein the second liquid is supplied from a recess formed on an upper surface of the movable stage to the upper surface so that the second liquid overflows to the upper surface.

10. The maintenance method according to any one of claims 1 to 9, wherein the cleaning step includes a step of ultrasonically vibrating the second liquid.

11. The maintenance method according to any one of claims 1 to 10, wherein the cleaning step includes a step of recovering the second liquid.

12. The maintenance method according to any one of claims 1 to 11, wherein the first liquid is different from the second liquid.

13. An exposure apparatus which exposes a substrate with an exposure light via an optical member and a first liquid, the exposure apparatus comprising:
a substrate stage which holds the substrate;
a liquid immersion space-forming member which forms a liquid immersion space by filling, with the first liquid, a space between the optical member and the substrate held by the substrate stage;
a movable stage which is arranged to be opposite to the liquid immersion space-forming member when the substrate stage is exchanged with the movable stage; and
a cleaning mechanism at least a part of which is provided on the movable stage and which cleans the liquid immersion space-forming member by supplying a second liquid to a space between the liquid immersion space-forming member and the cleaning mechanism.

14. The exposure apparatus according to claim 13, further comprising a projection optical system, wherein the optical member is a part of the projection optical system.

15. The exposure apparatus according to claim 13 or 14, wherein the movable stage has a measuring member which is used to obtain information necessary for liquid immersion exposure for the substrate.

16. The exposure apparatus according to claim 15, wherein the measuring member includes at least one of a sensor which detects the exposure light and a reference mark which is used for alignment of the substrate.

17. The exposure apparatus according to any one of claims 13 to 16, wherein the cleaning mechanism cleans at least a passage port, for the first liquid, of the liquid immersion space-forming member.

18. The exposure apparatus according to claim 17, wherein the passage port includes at least one of a supply port and the recovery port, for the first liquid, of the liquid immersion space-forming member.

19. The exposure apparatus according to claim 17 or 18, wherein the liquid immersion space-forming member has a mesh-shaped filter member which is provided on the passage port for the first liquid.

20. The exposure apparatus according to any one of claims 13 to 19, wherein the cleaning mechanism cleans at least a mesh-shaped filter member of the liquid immersion space-forming member.

21. The exposure apparatus according to any one of claims 13 to 20, wherein the movable stage has a recess to which the second liquid is supplied, and at least a part of the liquid immersion space-forming member which comes into contact with the first liquid is immersed in the second liquid.

22. The exposure apparatus according to claim 21, wherein the cleaning mechanism supplies the second liquid so that the second liquid overflows from the recess to an upper surface of the movable stage.

23. The exposure apparatus according to claim 21 or 22, wherein the recess has a size covering a substantially entire surface of a mesh-shaped filter member of the liquid immersion space-forming member.

24. The exposure apparatus according to any one of claims 13 to 23, wherein the first liquid is different from the second liquid.

25. The exposure apparatus according to any one of claims 13 to 24, wherein the cleaning mechanism includes an ultrasonic generator which vibrates the second liquid.

26. The exposure apparatus according to any one of claims 13 to 25, wherein the cleaning mechanism has a recovery mechanism which recovers the second liquid.

27. A method for producing a device, comprising:
exposing a substrate by using the exposure apparatus as defined in any one of claims 13 to 26;
developing the exposed substrate; and
processing the developed substrate.

28. An exposure method for forming a liquid immersion space by filling, with a first liquid, a space between an optical member and a substrate held by a substrate stage and exposing the substrate with an exposure light via the optical member and the first liquid, the exposure method comprising:
a moving step of arranging a movable stage to be opposite to a liquid immersion space-forming member which forms the liquid immersion space with the first liquid by exchanging the substrate stage with the movable stage; and
a cleaning step of cleaning the liquid immersion space-forming member by supplying a second liquid to a space between the liquid immersion space-forming member and the movable stage.

29. The exposure method according to claim 28, wherein the optical member is a part of a projection optical system.

30. The exposure method according to claim 28 or 29, wherein at least a part of the liquid immersion space-forming member which comes into contact with the first liquid at least during the exposure of the substrate is cleaned in the cleaning step.

31. The exposure method according to any one of claims 28 to 30, wherein at least a passage port, for the first liquid, of the liquid immersion space-forming member is cleaned in the cleaning step.

32. The exposure method according to any one of claims 28 to 31, wherein at least a mesh-shaped filter member of the liquid immersion space-forming member is cleaned in the cleaning step.

33. The exposure method according to any one of claims 28 to 32, wherein at least a part of the liquid immersion space-forming member is immersed in the second liquid in the cleaning step.

34. The exposure method according to any one of claims 28 to 33, wherein the second liquid is ultrasonically vibrated in the cleaning step.

35. The exposure method according to any one of claims 28 to 34, wherein the second liquid is recovered in the cleaning step.

36. The exposure method according to any one of claims 28 to 35, wherein the first liquid is different from the second liquid.

37. A method for producing a device, comprising:
exposing a substrate by using the exposure method as defined in any one of claims 28 to 36;
developing the exposed substrate; and
processing the developed substrate.

38. A maintenance method for an exposure apparatus which forms a liquid immersion space by filling a space between an optical member and a substrate with a first liquid and exposes the substrate with an exposure light via the optical member and the first liquid,
the maintenance method comprising a cleaning step of cleaning a liquid immersion space-forming member, which forms the liquid immersion space with the first liquid, by vibrating a second liquid in a predetermined space communicated with a passage port, for the first liquid, of the liquid immersion space-forming member.

39. The maintenance method according to claim 38, wherein the optical member is a part of a projection optical system of the exposure apparatus.

40. The maintenance method according to claim 38 or 39, wherein the second liquid is supplied to the predetermined space in the liquid immersion space-forming member via at least a part of a flow passage for the first liquid.

41. The maintenance method according to any one of claims 38 to 40, wherein the second liquid is supplied to the predetermined space in the liquid immersion space-forming member via the passage port.

42. The maintenance method according to any one of claims 38 to 41, wherein at least the passage port of the liquid immersion space-forming member is cleaned in the cleaning step.

43. The maintenance method according to any one of claims 38 to 42, wherein the passage port includes at least one of a supply port and a recovery port, for the first liquid, of the liquid immersion space-forming member.

44. The maintenance method according to any one of claims 38 to 43, wherein at least a mesh-shaped filter member provided on the passage port is cleaned.

45. The maintenance method according to any one of claims 38 to 44, wherein at least a mesh-shaped filter member of the liquid immersion space-forming member is cleaned in the cleaning step.

46. The maintenance method according to any one of claims 38 to 45, wherein the second liquid is supplied to the liquid immersion space-forming member through a passage at least a part of which is common to a recovery passage for the first liquid.

47. The maintenance method according to any one of claims 38 to 46, wherein the second liquid is supplied to the predetermined space via the passage port from a movable member which is arranged to be opposite to the optical member.

48. The maintenance method according to any one of claims 38 to 47, wherein the cleaning step includes a step of recovering the second liquid.

49. An exposure method for exposing a substrate with an exposure light via an optical member and a first liquid, the exposure method comprising a step of using the maintenance method as defined in any one of claims 38 to 48.

50. An exposure method for exposing a substrate with an exposure light via an optical member and a first liquid, the exposure method comprising cleaning a liquid immersion space-forming member, which forms a liquid immersion space by filling a space between the optical member and the substrate with the first liquid, by vibrating a second liquid in a predetermined space communicated with a passage port, for the first liquid, of the liquid immersion space-forming member.

51. A method for producing a device, comprising:
exposing a substrate by using the exposure method as defined in claim 49 or 50;
developing the exposed substrate; and
processing the developed substrate.

52. A maintenance method for an exposure apparatus which forms a liquid immersion space by filling a space between an optical member and a substrate with a first liquid and exposes the substrate with an exposure light via the optical member and the first liquid, the maintenance method comprising:
a moving step of arranging a movable member to be opposite to a liquid immersion space-forming member which forms the liquid immersion space with the first liquid; and
a cleaning step of jetting a second liquid from the movable member toward a passage port, for the first liquid, of the liquid immersion space-forming member to clean the liquid immersion space-forming member.

53. The maintenance method according to claim 52, wherein the optical member is a part of a projection optical system of the exposure apparatus.

54. The maintenance method according to claim 52 or 53, wherein the passage port includes at least one of a supply port and a recovery port, for the first liquid, of the liquid immersion space-forming member.

55. The maintenance method according to any one of claims 52 to 54, wherein at least a mesh-shaped filter member provided on the passage port is cleaned in the cleaning step.

56. The maintenance method according to any one of claims 52 to 55, wherein at least a mesh-shaped filter member of the liquid immersion space-forming member is cleaned in the cleaning step.

57. The maintenance method according to any one of claims 52 to 56, wherein the cleaning step includes a step of sucking a gas in an atmosphere in which the second liquid is jetted.

58. The maintenance method according to any one of claims 52 to 57, wherein the cleaning step includes a step of moving the movable member relative to the liquid immersion space-forming member while jetting the second liquid.

59. The maintenance method according to any one of claims 52 to 58, wherein the first liquid is different from the second liquid.

60. The maintenance method according to any one of claims 52 to 59, wherein the movable member, which is different from a movable member holding the substrate, is used.

61. An exposure method for exposing a substrate with an exposure light via an optical member and a first liquid, the exposure method comprising a step of using the maintenance method as defined in any one of claims 52 to 60.

62. An exposure method for exposing a substrate with an exposure light via an optical member and a first liquid,
the exposure method comprising cleaning a liquid immersion space-forming member, which forms a liquid immersion space by filling a space between the optical member and the substrate with the first liquid, by jetting a second liquid from a movable member, different from a movable member holding the substrate, toward the liquid immersion space-forming member.

63. A method for producing a device, comprising:
exposing a substrate by using the exposure method as defined in claim 61 or 62;
developing the exposed substrate; and
processing the developed substrate.

64. An exposure apparatus which exposes a substrate with an exposure light via an optical member and a first liquid, the exposure apparatus comprising:
a liquid immersion space-forming member which forms a liquid immersion space by filling a space between the optical member and the substrate with the first liquid;
a liquid supply mechanism which supplies a second liquid into a predetermined space communicated with a passage port, for the first liquid, of the liquid immersion space-forming member; and
a vibration device which vibrates the second liquid in the predetermined space.

65. The exposure apparatus according to claim 64, further comprising a projection optical system, wherein the optical member is a part of the projection optical system.

66. The exposure apparatus according to claim 64 or 65, wherein the liquid supply mechanism supplies the second liquid to the predetermined space via the passage port.

67. The exposure apparatus according to any one of claims 64 to 66, wherein at least the passage port is cleaned by vibration of the second liquid in the predetermined space.

68. The exposure apparatus according to any one of claims 64 to 67, wherein the passage port includes at least one of a supply port and a recovery port, for the first liquid, of the liquid immersion space-forming member.

69. The exposure apparatus according to any one of claims 64 to 68, wherein a mesh-shaped filter member is provided on the passage port of the liquid immersion space-forming member.

70. The exposure apparatus according to any one of claims 64 to 69, wherein at least a mesh-shaped filter member of the liquid immersion space-forming member is cleaned by vibration of the second liquid in the predetermined space.

71. The exposure apparatus according to any one of claims 64 to 70, wherein the second liquid is supplied to the liquid immersion space-forming member by the liquid supply mechanism along with a passage at least a part of which is common to a recovery passage for the first liquid.

72. The exposure apparatus according to any one of claims 64 to 71, wherein the vibration device includes a stirring device which stirs the second liquid.

73. The exposure apparatus according to claim 72, wherein the stirring device includes a stirring bar which is arranged in the predetermined space, and a driving device which is provided for a movable member arranged to be opposite to the optical member and which drives the stirring bar.

74. The exposure apparatus according to any one of claims 64 to 73, wherein the liquid supply mechanism supplies the second liquid to the predetermined space via the passage port from a movable member arranged to be opposite to the optical member.

75. The exposure apparatus according to claim 73 or 74, wherein the movable member is different from a movable member which holds the substrate.

76. The exposure apparatus according to any one of claims 64 to 75, wherein the vibration device includes an ultrasonic wave generator which generates an ultrasonic wave in the second liquid.

77. The exposure apparatus according to any one of claims 64 to 76, wherein the liquid supply mechanism has a supply passage at least a part of which is common to a flow passage for the first liquid.

78. The exposure apparatus according to any one of claims 64 to 77, further comprising a liquid recovery mechanism which recovers the second liquid.

79. The exposure apparatus according to any one of claims 64 to 78, wherein the liquid supply mechanism has a detachable vessel which accommodates the second liquid.

80. The exposure apparatus according to any one of claims 64 to 79, wherein the first liquid is different from the second liquid.

81. A method for producing a device, comprising:
exposing a substrate by using the exposure apparatus as defined in any one of claims 64 to 80;
developing the exposed substrate; and
processing the developed substrate.

82. An exposure apparatus which exposes a substrate with an exposure light via an optical member and a first liquid, the exposure apparatus comprising:
a liquid immersion space-forming member which forms a liquid immersion space by filling a space between the optical member and the substrate with the first liquid;
a movable member which is arranged to be opposite to the liquid immersion space-forming member; and
a jetting device which jets a second liquid from the movable member toward a passage port, for the first liquid, of the liquid immersion space-forming member so as to clean the liquid immersion space-forming member.

83. The exposure apparatus according to claim 82, further comprising a projection optical system, wherein the optical member is a part of the projection optical system.

84. The exposure apparatus according to claim 82 or 83, wherein the passage port includes at least one of a supply port and a recovery port, for the first liquid, of the liquid immersion space-forming member.

85. The exposure apparatus according to any one of claims 82 to 84, wherein a mesh-shaped filter member is provided on the passage port of the liquid immersion space-forming member.

86. The exposure apparatus according to any one of claims 82 to 85, wherein at least a mesh-shaped filter member of the liquid immersion space-forming member is cleaned by jetting of the second liquid.

87. The exposure apparatus according to any one of claims 82 to 86, further comprising a sucking device which sucks a gas and the liquid from a position in the vicinity of a jetting port provided on an upper surface of the movable member.

88. The exposure apparatus according to any one of claims 82 to 87, further comprising a controller which moves the movable member relative to the liquid immersion space-forming member while jetting the second liquid by the jetting device.

89. The exposure apparatus according to any one of claims 82 to 88, wherein the movable member is different from a movable member which holds the substrate.

90. The exposure apparatus according to any one of claims 82 to 89, wherein the first liquid is different from the second liquid.

91. A method for producing a device, comprising:
exposing a substrate by using the exposure apparatus as defined in any one of claims 82 to 90;
developing the exposed substrate; and
processing the developed substrate.

92. A maintenance method for an exposure apparatus which forms a liquid immersion space by filling a space between an optical member and a substrate with a first liquid and exposes the substrate with an exposure light via the optical member and the first liquid, the maintenance method comprising:
a moving step of arranging a movable member to be opposite to a liquid immersion space-forming member which forms the liquid immersion space with the first liquid; and
a cleaning step of cleaning the liquid immersion space-forming member by a flexible cleaning member which is provided on the movable member.

93. The maintenance method according to claim 92, wherein the optical member is a part of a projection optical system of the exposure apparatus.

94. The maintenance method according to claim 92 or 93, wherein the cleaning step further comprises a step of vibrating the cleaning member relative to the liquid immersion space-forming member.

95. The maintenance method according to any one of claims 92 to 94, wherein in the cleaning step, a cleaning liquid is used to clean the liquid immersion space-forming member by the cleaning member.

96. The maintenance method according to claim 95, wherein the cleaning liquid is supplied from at least one of the cleaning member and the liquid immersion space-forming member.

97. The maintenance method according to any one of claims 92 to 96, wherein the cleaning step comprises a step of supplying a second liquid to the liquid immersion space-forming member continuously to the cleaning step performed by the cleaning member.

98. The maintenance method according to claim 97, wherein the first liquid is different from the second liquid.

99. The maintenance method according to any one of claims 92 to 98, wherein the cleaning member is provided on a self-propelled mechanism which is movable on the movable member.

100. The maintenance method according to any one of claims 92 to 99, wherein the cleaning member is provided on a surface of a dummy substrate which is arranged, instead of the substrate, on a substrate stage holding the substrate.

101. The maintenance method according to any one of claims 92 to 100, wherein the movable member is a substrate stage which holds the substrate or a stage which is movable independently from the substrate stage.

102. The maintenance method according to any one of claims 92 to 101, wherein the movable member is driven by an actuator of a substrate stage which holds the substrate or of a stage which is movable independently from the substrate stage.

103. The maintenance method according to claim 102, wherein the movable member is driven by the actuator by being exchanged with or connected to the substrate stage or the movable stage.

104. The maintenance method according to any one of claims 92 to 103, wherein at least a passage port of the liquid immersion space-forming member is cleaned in the cleaning step.

105. The maintenance method according to claim 104, wherein the passage port includes at least one of a supply port and a recovery port, for the first liquid, of the liquid immersion space-forming member.

106. The maintenance method according to any one of claims 92 to 105, wherein at least a mesh-shaped filter member of the liquid immersion space-forming member is cleaned in the cleaning step.

107. An exposure method for exposing a substrate with an exposure light via an optical member and a first liquid, the exposure method comprising a step of using the maintenance method as defined in any one of claims 92 to 106.

108. An exposure method for exposing a substrate with an exposure light via an optical member and a first liquid,
the exposure method comprising arranging a movable member to be opposite to a liquid immersion space-forming member which forms a liquid immersion space by filling a space between the optical member and the substrate with the first liquid, and cleaning the liquid immersion space-forming member by a flexible cleaning member of the movable member.

109. A method for producing a device, comprising:
exposing a substrate by using the exposure method as defined in claim 107 or 108;
developing the exposed substrate; and
processing the developed substrate.

110. A maintenance method for an exposure apparatus which forms a liquid immersion space by filling a space between an optical member and a substrate with a first liquid and exposes the substrate with an exposure light via the optical member and the first liquid, the maintenance method comprising:
a liquid immersion step of arranging a movable member to be opposite to a liquid immersion space-forming member which forms the liquid immersion space with the first liquid and supplying the first liquid onto the movable member; and
a cleaning step of cleaning the liquid immersion space-forming member by using a gas supplied to surround the liquid immersion space during the exposure.

111. The maintenance method according to claim 110, wherein the optical member is a part of a projection optical system of the exposure apparatus.

112. The maintenance method according to claim 110 or 111, wherein in the cleaning step, the gas is supplied to a passage port, for the first liquid, of the liquid immersion space-forming member via the first liquid.

113. The maintenance method according to any one of claims 110 to 112, wherein a surface of the movable member to which the first liquid is supplied in the liquid immersion step, is porous.

114. The maintenance method according to any one of claims 110 to 113, wherein a dummy substrate, which has a porous surface, is arranged on the movable member instead of the substrate in the liquid immersion step, and the first liquid is supplied onto the dummy substrate.

115. The maintenance method according to any one of claims 110 to 114, wherein at least one of a supply port and a recovery port, for the first liquid, of the liquid immersion space-forming member is at least cleaned in the cleaning step.

116. The maintenance method according to any one of claims 110 to 115, wherein in the cleaning step, at least a mesh-shaped filter member of the liquid immersion space-forming member is cleaned.

117. The maintenance method according to any one of claims 110 to 116, wherein at least a part, of the liquid immersion space-forming member, which comes into contact with the first liquid is cleaned in the cleaning step.

118. An exposure method for exposing a substrate with an exposure light via an optical member and a first liquid, the exposure method comprising a step of using the maintenance method as defined in any one of claims 110 to 117.

119. An exposure method for exposing a substrate with an exposure light via an optical member and a first liquid, the exposure method comprising:
arranging a movable member to be opposite to a liquid immersion space-forming member which forms a liquid immersion space with the first liquid, supplying the first liquid onto the movable member, and cleaning the liquid immersion space-forming member by using a gas supplied to surround the liquid immersion space during the exposure.

120. A method for producing a device, comprising:
exposing a substrate by using the exposure method as defined in claim 118 or 119;
developing the exposed substrate; and
processing the developed substrate.

121. An exposure apparatus which forms a liquid immersion space by filling a space between an optical member and a substrate with a first liquid and exposes the substrate with an exposure light via the optical member and the first liquid, the exposure apparatus comprising:
a liquid immersion space-forming member which forms the liquid immersion space with the first liquid;
a movable member which is arranged to be opposite to the optical member; and
a cleaning mechanism which has a flexible cleaning member arranged on the movable member and which cleans the liquid immersion space-forming member by moving the cleaning member relative to at least a part of the liquid immersion space-forming member while bringing the cleaning member and at least the part of the liquid immersion space-forming member into contact with each other.

122. The exposure apparatus according to claim 121, further comprising a projection optical system, wherein the optical member is a part of the projection optical system.

123. The exposure apparatus according to claim 121 or 122, wherein the cleaning mechanism vibrates the cleaning member relative to the liquid immersion space-forming member.

124. The exposure apparatus according to any one of claims 121 to 123, wherein the cleaning mechanism cleans at least a passage port of the liquid immersion space-forming member.

125. The exposure apparatus according to claim 124, wherein the passage port includes at least one of a supply port and a recovery port, for the first liquid, of the liquid immersion space-forming member.

126. The exposure apparatus according to any one of claims 121 to 125, wherein the cleaning mechanism cleans at least a mesh-shaped filter member of the liquid immersion space-forming member.

127. The exposure apparatus according to any one of claims 121 to 126, wherein the cleaning mechanism supplies a cleaning liquid to a contact portion between the liquid immersion space-forming member and the cleaning member.

128. The exposure apparatus according to claim 127, wherein the cleaning mechanism supplies the cleaning liquid from at least one of the cleaning member and the liquid immersion space-forming member.

129. The exposure apparatus according to claim 127, wherein the cleaning mechanism supplies the cleaning liquid from the liquid immersion space-forming member toward the cleaning member.

130. The exposure apparatus according to claim 127 or 129, wherein the cleaning mechanism supplies the cleaning liquid from a gap of the cleaning member toward the liquid immersion space-forming member.

131. The exposure apparatus according to any one of claims 121 to 130, wherein the cleaning mechanism supplies a second liquid to the liquid immersion space-forming member during a period in which the cleaning member and the liquid immersion space-forming member come into contact with each other or after a cleaning operation performed by the cleaning member.

132. The exposure apparatus according to claim 131, wherein the first liquid is different from the second liquid.

133. The exposure apparatus according to any one of claims 121 to 132, wherein the cleaning mechanism includes a self-propelled mechanism which is movable on the movable member while holding the cleaning member.

134. The exposure apparatus according to any one of claims 121 to 133, wherein the cleaning member is provided on a surface of a dummy substrate which is arranged on a substrate stage holding the substrate, instead of the substrate.

135. The exposure apparatus according to any one of claims 121 to 134, wherein the movable member is a substrate stage which holds the substrate or a stage which is movable independently from the substrate stage.

136. The exposure apparatus according to any one of claims 121 to 135, wherein the movable member is driven by an actuator of a substrate stage which holds the substrate or of a stage which is movable independently from the substrate stage.

137. The exposure apparatus according to claim 136, wherein the movable member is driven by the actuator by being exchanged with or connected to the substrate stage or the movable stage.

138. A method for producing a device, comprising:
exposing a substrate by using the exposure apparatus as defined in any one of claims 121 to 137;
developing the exposed substrate; and
processing the developed substrate.

139. An exposure apparatus which forms a liquid immersion space by filling a space between an optical member and a substrate with a first liquid and exposes the substrate with an exposure light via the optical member and the first liquid, the exposure apparatus comprising:
a liquid immersion space-forming member which forms the liquid immersion space with the first liquid;
a gas supply mechanism which supplies a gas such that the gas surrounds the liquid immersion space during the exposure of the substrate;
a movable member which is arranged to be opposite to the optical member;
a liquid supply section which supplies the first liquid onto the movable member via the liquid immersion space-forming member; and
a controller which allows the gas supply mechanism to supply the gas to an area on the movable member to which the first liquid is supplied so as to clean the liquid immersion space-forming member.

140. The exposure apparatus according to claim 139, further comprising a projection optical system, wherein the optical member is a part of the projection optical system.

141. The exposure apparatus according to claim 139 or 140, wherein the gas supply mechanism supplies the gas to a passage port, for the first liquid, of the liquid immersion space-forming member via the first liquid.

142. The exposure apparatus according to claim 141, wherein the passage port includes at least one of a supply port and a recovery port, for the first liquid, of the liquid immersion space-forming member.

143. The exposure apparatus according to claim 141 or 142, wherein a mesh-shaped filter member is disposed on the passage port.

144. The exposure apparatus according to any one of claims 139 to 143, wherein a surface of the movable member to which the first liquid is supplied is porous.

145. The exposure apparatus according to any one of claims 139 to 144, wherein the gas supply mechanism supplies the gas to at least a mesh-shaped filter member and/or a recovery port for the first liquid of the liquid immersion space-forming member.

146. A method for producing a device, comprising:
exposing a substrate by using the exposure apparatus as defined in any one of claims 139 to 145;
developing the exposed substrate; and
processing the developed substrate.

147. A maintenance method for an exposure apparatus which exposes a substrate with an exposure light via an optical member and a first liquid,
the maintenance method comprising cleaning a liquid contact portion which comes into contact with the first liquid by a cleaning member at least a part of which is provided on a second movable member different from a first movable member holding the substrate.

148. The maintenance method according to claim 147, wherein a second liquid is used during the cleaning.

149. The maintenance method according to claim 148, wherein the second liquid is vibrated during the cleaning.

150. The maintenance method according to claim 148 or 149, wherein the second liquid is a cleaning liquid which is different from the first liquid.

151. The maintenance method according to any one of claims 147 to 150, wherein the cleaning member is brought into contact with the liquid contact portion during the cleaning.

152. The maintenance method according to any one of claims 147 to 151, wherein the liquid contact portion includes a nozzle member which forms a liquid immersion space by filling a space between the optical member and the substrate with the first liquid.

153. An exposure method for exposing a substrate with an exposure light via an optical member and a first liquid, the exposure method comprising a step of using the maintenance method as defined in any one of claims 147 to 152.

154. An exposure method for exposing a substrate with an exposure light via an optical member and a first liquid,
the exposure method comprising cleaning a liquid contact portion, which comes into contact with the first liquid, by a cleaning member at least a part of which is provided on a second movable member different from a first movable member holding the substrate.

155. A method for producing a device, comprising:
exposing a substrate by using the exposure method as defined in claim 153 or 154;
developing the exposed substrate; and
processing the developed substrate.

156. An exposure apparatus which exposes a substrate with an exposure light via an optical member and a first liquid, the exposure apparatus comprising:
a first movable member which holds the substrate;
a second movable member which is different from the first movable member; and
a cleaning member at least a part of which is provided on the second movable member and which cleans a liquid contact portion which comes into contact with the first liquid.

157. The exposure apparatus according to claim 156, wherein the cleaning member uses a second liquid during the cleaning.

158. The exposure apparatus according to claim 157, wherein the cleaning member includes an ultrasonic vibrator which vibrates the second liquid.

159. The exposure apparatus according to any one of claims 156 to 158, wherein the cleaning member comes into contact with the liquid contact portion during the cleaning.

160. The exposure apparatus according to any one of claims 156 to 159, wherein at least a part of a measuring member is provided on an upper surface of the second movable member.

161. An exposure apparatus which exposes a substrate with an exposure light via an optical member and a first liquid, the exposure apparatus comprising:
a movable member which is arranged to be opposite to the optical member; and
a cleaning mechanism at least a part of which is provided on the movable member and which cleans a liquid contact portion, which comes into contact with the first liquid, by moving a cleaning member relative to the liquid contact portion while bringing the cleaning member and the liquid contact portion into contact with each other.

162. The exposure apparatus according to any one of claims 156 to 161, further comprising a nozzle member which forms a liquid immersion space by filling a space between the optical member and the substrate with the first liquid, wherein the liquid contact portion includes the nozzle member.

163. A method for producing a device, comprising:
exposing a substrate by using the exposure apparatus as defined in any one of claims 156 to 162;
developing the exposed substrate; and
processing the developed substrate.
